(19)

Europäisches
Patentamt
European
Patent Office
Office européen
des brevets

(11) **EP 4 506 435 A1**

(12) **EUROPEAN PATENT APPLICATION**

(43) Date of publication:
**12.02.2025 Bulletin 2025/07**

(21) Application number: **24193592.3**

(22) Date of filing: **08.08.2024**

(51) International Patent Classification (IPC):
***C09K 11/02*** (2006.01)　　***C09K 11/62*** (2006.01)

(52) Cooperative Patent Classification (CPC):
**C09K 11/02; C09K 11/621**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.08.2023　KR 20230103800**

(71) Applicant: **Samsung Electronics Co., Ltd
Suwon-si, Gyeonggi-do 16677 (KR)**

(72) Inventors:
　• **YANG, Seungrim
　　16678 Suwon-si (KR)**

• **KIM, Minho
　16678 Suwon-si (KR)**
• **MOON, Deuk Kyu
　16678 Suwon-si (KR)**
• **WON, Nayoun
　16678 Suwon-si (KR)**
• **CHAE, Sue In
　16678 Suwon-si (KR)**
• **KIM, Tae-Gon
　16678 Suwon-si (KR)**
• **LEE, Jun Ho
　16678 Suwon-si (KR)**

(74) Representative: **Elkington and Fife LLP
Prospect House
8 Pembroke Road
Sevenoaks, Kent TN13 1XR (GB)**

(54) **SEMICONDUCTOR NANOPARTICLE, PRODCUTION METHOD THEREOF, ELECTRONIC DEVICE INCLUDING THE SAME**

(57) A method of manufacturing a semiconductor nanoparticle, the semiconductor nanoparticle manufactured therefrom, and an electronic device including the semiconductor nanoparticle. The method of manufacturing the semiconductor nanoparticle includes combining a first semiconductor nanocrystal that includes silver, a Group 13 element, and a chalcogen element, with a gallium precursor, a sulfur precursor, and a silver compound in a medium including an organic solvent; and heating the medium to a reaction temperature to obtain a crude solution including the semiconductor nanoparticles. The semiconductor nanoparticle includes silver, indium, gallium, and sulfur, and the size is greater than or equal to about 2 nm and less than or equal to about 50 nm.

**EP 4 506 435 A1**

**FIG. 1A**

Pattern Preparation by using a photoresist

| coating: spin coating | — S1 |

| Pre-bake (PRB) | — S2 |

| UV exposure under a Mask (EXP) | — S3 |

| Development (DEV) | — S4 |

| Post-bake (POB) | — S5 |

BM　　　　RGB

— S6

Repeating three times of patterning process for each pixel

**Description**

FIELD OF THE INVENTION

A semiconductor nanoparticle, a method of producing the semiconductor nanoparticle, and an electronic device including the semiconductor nanoparticle are disclosed.

BACKGROUND OF THE INVENTION

A semiconductor nanoparticle may exhibit different characteristics or properties than a corresponding bulk material having substantially the same composition. For example, the semiconductor nanoparticle may have different physical properties based on the nanostructure (e.g., bandgap energy, a luminescent property, or the like). The semiconductor nanoparticle may be configured to emit light upon excitation by incident light or an applied voltage. The luminescent nanostructure may find applicability in a variety of devices (e.g., a display panel or an electronic device including the display panel). From an environmental point of view, developing a luminescent nanoparticle that does not contain a harmful heavy metal such as cadmium, and yet provide an improved luminescent property is desirable and of interest.

SUMMARY OF THE INVENTION

An aspect relates to a manufacturing method of a semiconductor nanoparticle exhibiting improved properties with an increase in yield.

An aspect relates to a semiconductor nanoparticle, and a population of semiconductor nanoparticles, manufactured in accordance with a method of an embodiment.

An aspect relates to a method of producing the semiconductor nanoparticle.

An aspect relates to a composition (e.g., an ink composition) including the semiconductor nanoparticle.

An aspect relates to a color conversion panel including the semiconductor nanoparticle.

An aspect provides a method of manufacturing a semiconductor nanoparticle, the method of which includes: combining a first semiconductor nanocrystal that includes silver, a Group 13 element, and a chalcogen element, with a gallium precursor, a sulfur precursor, and a silver compound in a medium including an organic solvent; and heating the medium to a reaction temperature to obtain a crude solution including the semiconductor nanoparticle. The semiconductor nanoparticle includes silver, indium, gallium, and sulfur, and a size of the semiconductor nanoparticle is greater than or equal to about 2 nanometers (nm) and less than or equal to about 50 nm, for example, 10 nm or less.

The method may further include adding a non-solvent to the crude solution to facilitate precipitation of the semiconductor nanoparticle followed by separating or recovering the semiconductor nanoparticle from the mixture.

A crude solution may have an optical density defined by Equation 1 at a wavelength of 500 nm that is greater than or equal to about 1 and less than or equal to about 10:

$$\text{Equation 1}$$

$$\text{Optical density} = \log_{10}(I_O/I_T)$$

$I_O$ = intensity of incident light supplied to the crude solution
$I_T$ = intensity of transmitted light passing through the crude solution.

At a wavelength of 500 nm, the optical density of the crude solution may be greater than or equal to 1.5 and less than or equal to 5.

At a wavelength of 350 nm, the crude solution may have an optical density of greater than or equal to about 8, for example, greater than or equal to about 10. The crude solution may have an optical density of less than or equal to about 100 at a wavelength of 350 nm. For example, at a wavelength of 350 nm, the optical density of the crude solution may be greater than or equal to about 12 and less than or equal to about 50.

In the UV-Vis absorption spectrum of the crude solution, a ratio of absorption at 500 nm to absorption at 350 nm ($A_{500}:A_{350}$) may be greater than or equal to about 0.01:1 and less than or equal to about 0.8:1.

The silver compound may be added to the medium in an amount of greater than or equal to about 0.1 % by mol, for example, greater than or equal to about 0.5% by mol.

The silver compound may be added to the medium in an amount of less than or equal to about 50% by mol, for example, less than or equal to about 25% by mol, relative to the gallium precursor.

The amount of the silver compound may be greater than or equal to about 1 mol% and less than or equal to about 12 mol%.

The silver compound may include a silver carboxylate, a silver acetylacetonate, a silver halide, or a combination thereof.

In an embodiment, the combining may be performed at a predetermined temperature (e.g., a first temperature). The first temperature may be greater than or equal to about 120°C (e.g., greater than or equal to about 180°C, or greater than or equal to about 190°C, greater than or equal to about 200°C) and less than the reaction temperature, e.g., less than or equal to about 280°C (e.g., less than or equal to about 250°C).

The reaction temperature can be greater than or equal to about 210 °C and less than or equal to about 380 °C.

The Group 13 element may contain indium, gallium, or indium and gallium.

The chalcogen element may include sulfur, selenium, or sulfur and selenium. The first semiconductor nanocrystal may include (a group 11-13-16 compound including) silver, indium, gallium, and sulfur.

In a method in accordance with an embodiment, a production yield determined by the following equation may be greater than or equal to about 6%:

$$\text{Production yield} = A/B \times 100$$

A: a total weight of silver, a Group 13 element, and sulfur among the semiconductor nanoparticles recovered from the solution

B: a total weight of silver, Group 13 element, and sulfur added to the reaction, i.e., the initial weight of silver, Group 13 metal, and sulfur in the respective element precursors added to the reaction medium.

The production yield may be greater than or equal to about 10%. The production yield may be less than or equal to about 100%, less than or equal to about 90%, less than or equal to about or 60%.

The semiconductor nanoparticles may be configured to emit first light (e.g., green light).

The first light may have a peak emission wavelength of greater than or equal to about 500 nm and less than or equal to about 600 nm. The peak emission wavelength of the green light may be in a range of greater than or equal to about 500 nm, or greater than or equal to about 505 nm and less than or equal to about 580 nm, or less than or equal to about 550 nm.

The semiconductor nanoparticle may have a (absolute) quantum yield of greater than or equal to about 65% or greater than or equal to about 70%. The quantum yield may be less than or equal to about 98% or less than or equal to about 90%.

The semiconductor nanoparticle may have a full width at half maximum (FWHM) of less than or equal to about 70 nm, less than or equal to about 40 nm, or less than or equal to about 35 nm. The FWHM may be greater than or equal to about 5 nm, greater than or equal to about 10 nm, greater than or equal to about 15 nm, or greater than or equal to about 25 nm. For example, the semiconductor nanoparticle may have a FWHM from about 15 nm to about 40 nm.

The semiconductor nanoparticle may have a size or an average size (hereinafter, "size") of greater than or equal to about 5 nm and less than or equal to about 10 nm or less, and a standard deviation of less than or equal to about 20% of the average size. The standard deviation may be less than or equal to about 15% or less than or equal to about 13%. For example, the size may be greater than or equal to about 5 nm and less than or equal to about 8 nm.

In an embodiment, the semiconductor nanoparticle may have a charge balance value determined by the following equation that is greater than or equal to about 0.8 or greater than or equal to about 0.9. The semiconductor nanoparticle may have a charge balance value determined by the following equation that is less than or equal to about 1.4 or less than or equal to about 1.2:

$$\text{charge balance value} = \{[Ag] + 3([In]+[Ga])\}/(2[S])$$

wherein, in the equation, [Ag], [In], [Ga], and [S] are molar amounts of silver, indium, gallium, and sulfur in the semiconductor nanoparticle, respectively.

The semiconductor nanoparticle may include the first semiconductor nanocrystal and a second semiconductor nanocrystal including silver, gallium, and sulfur. The second semiconductor nanocrystal may be disposed on the first semiconductor nanocrystal.

The method may further include preparing an additional medium that includes a zinc precursor and optionally an organic ligand in an organic solvent; adding the formed semiconductor nanoparticle and a chalcogen precursor to the additional medium, and heating the additional medium to a reaction temperature to form a third semiconductor nanocrystal including a zinc chalcogenide or an outer layer including a zinc chalcogenide on a surface of the semiconductor nanoparticle. The third semiconductor nanocrystal may have a composition different from that of the first semiconductor nanocrystal and the second semiconductor nanocrystal.

In the semiconductor nanoparticle, the third semiconductor nanocrystal may be disposed on the second semiconductor nanocrystal. If present, the third semiconductor nanocrystal may be an outermost layer of the semiconductor nanoparticle.

The first semiconductor nanocrystal may not include zinc. The semiconductor nanoparticle may further include or may not include lithium. The semiconductor nanoparticle may further include or may not include an alkali metal (e.g., lithium, sodium, potassium, etc.).

In the semiconductor nanoparticle, a mole ratio of gallium to indium (Ga:In) may be greater than or equal to about 1:1, greater than or equal to about 3.3:1, or greater than or equal to about 3.5:1, and less than or equal to about 10:1, less than or equal to about 8:1, less than or equal to about 6.5:1, less than or equal to about 5.5:1, or less than or equal to about 4.1:1.

In the semiconductor nanoparticle, a mole ratio of gallium to a sum of indium and gallium (Ga:(In+Ga)) may be greater than or equal to about 0.7:1, or greater than or equal to about 0.75:1, and less than or equal to about 0.99:1, less than or equal to about 0.85:1, or less than or equal to about 0.82:1.

In the semiconductor nanoparticle, a mole ratio of gallium to silver (Ga:Ag) may be greater than or equal to about 1.1:1, or greater than or equal to about 1.35:1. In the semiconductor nanoparticle, a mole ratio of gallium to silver (Ga:Ag) may be less than or equal to about 3:1, less than or equal to about 2:1, or less than or equal to about 1.58:1.

In the semiconductor nanoparticle, a mole ratio of gallium to a sum of gallium, indium, and silver (Ga:(Ga+In+Ag)) may be greater than or equal to about 0.45:1, greater than or equal to about 0.50:1, or greater than or equal to about 0.51:1 and less than or equal to about 0.6:1 or less than or equal to about 0.52:1.

In the semiconductor nanoparticle, a mole ratio of a sum of indium and gallium to silver ((In+Ga):Ag) may be greater than or equal to about 1.2:1, greater than or equal to about 1.4:1, or greater than or equal to about 1.7:1. In the semiconductor nanoparticle, a mole ratio of a sum of indium and gallium to silver ((In+Ga):Ag) may be less than or equal to about 3.7:1, less than or equal to about 3.5:1, or less than or equal to about 2:1.

In the semiconductor nanoparticle, a mole ratio of silver to sulfur (Ag:S) may be greater than or equal to about 0.05:1, greater than or equal to about 0.2:1, or greater than or equal to about 0.32:1. The mole ratio of silver to sulfur (Ag:S) may be less than or equal to about 0.5:1, less than or equal to about 0.41:1, or less than or equal to about 0.35:1.

In the semiconductor nanoparticle, a mole ratio of silver to indium (Ag:In) may be greater than or equal to about 1.5:1, greater than or equal to about 2:1, or greater than or equal to about 2.5:1. In the semiconductor nanoparticle, a mole ratio of silver to indium (Ag:In) may be less than or equal to about 6:1, less than or equal to about 4.5:1, or less than or equal to about 3:1.

In the semiconductor nanoparticle, a mole ratio of silver to a sum of silver, indium, and gallium (Ag:(Ag+In+Ga)) may be greater than or equal to about 0.2:1, greater than or equal to about 0.3:1, or greater than or equal to about 0.35:1. In the semiconductor nanoparticle, a mole ratio of silver to a sum of silver, indium, and gallium (Ag:(Ag+In+Ga)) may be less than or equal to about 0.45:1, or less than or equal to about 0.41:1.

In the semiconductor nanoparticle, a mole ratio of sulfur to a sum of silver, indium, and gallium (S:(Ag+In+Ga)) may be greater than or equal to about 0.8:1, greater than or equal to about 0.9:1, or greater than or equal to about 1:1. In the semiconductor nanoparticle, a mole ratio of sulfur to a sum of silver, indium, and gallium (S:(Ag+In+Ga)) may be less than or equal to about 1.5:1, less than or equal to about 1.3:1, less than or equal to about 1.13:1, or less than or equal to about 1.08:1.

In the semiconductor nanoparticle, a mole ratio of sulfur to gallium (Ga:S) may be greater than or equal to about 0.4:1, or greater than or equal to about 0.44:1. In the semiconductor nanoparticle, a mole ratio of sulfur to gallium (Ga:S) may be less than or equal to about 0.6:1 or less than or equal to about 0.51:1.

The green light may include band edge emission.

An embodiment provides the semiconductor nanoparticles described herein or a population thereof.

In an embodiment, the semiconductor nanoparticles may include a first semiconductor nanocrystal containing silver, indium, gallium, and sulfur, and an average size of the semiconductor nanoparticles may be greater than or equal to about 5 nm and less than or equal to about 8 nm, or less than or equal to about 7.5 nm, and a standard deviation of the semiconductor nanoparticles may be less than or equal to about 20% or less than or equal to about 15%, and greater than or equal to about 5% of the average size.

The semiconductor nanoparticles may be configured to emit first light (e.g., green light or red light), and the semiconductor nanoparticle may have a charge balance value that is greater than or equal to about 0.95 and less than or equal to about 1.2:

$$\text{charge balance value} = \{[Ag] + 3([In]+[Ga])\}/(2[S])$$

wherein, in the above equation, [Ag], [In], [Ga], and [S] are molar amounts of silver, indium, gallium, and sulfur in the semiconductor nanoparticle, respectively.

The semiconductor nanoparticles may be configured to emit green light. The semiconductor nanoparticles may be configured to emit red light.

The green light may have a peak emission wavelength of greater than or equal to about 520 nm and less than or equal to about 540 nm. The red light may have a peak emission wavelength of greater than or equal to about 600 nm and less than or equal to about 650 nm.

In an embodiment, an ink composition includes the semiconductor nanoparticle and a liquid vehicle. The semiconductor nanoparticle or a population thereof may be dispersed in the liquid vehicle. The liquid vehicle may include a liquid monomer, a (volatile) organic solvent, or a combination thereof. The ink composition may not substantially include a volatile organic solvent. The ink composition may further include a metal oxide fine particle.

In an embodiment, a composite includes a matrix and the semiconductor nanoparticle dispersed in the matrix. The composite may further include a metal oxide fine particle. The composite may be configured to emit green light. The composite may be a patterned film. The composite may further include a semiconductor nanoparticle configured to emit a second light different from the green light.

An embodiment provides a color conversion layer (e.g., a color conversion structure or a color conversion panel) including a color conversion zone containing the aforementioned semiconductor nanoparticles.

The color conversion panel or color conversion structure includes a color conversion layer including a color conversion area and a partition wall defining each area of the color conversion layer according to selection, the color conversion area includes a first area corresponding to a first pixel, and the first area includes the semiconductor nanoparticles or the composite.

In an embodiment, a display panel or an electronic device includes a light source and a color conversion layer (e.g., a color conversion structure) disposed on the light source.

In an embodiment, the display panel includes a light-emitting panel (or a light source), the color conversion panel, and optionally a light-transmitting layer positioned between the light-emitting panel and the color conversion panel.

The light emitting panel (or light source) may be configured to provide (or provides) an incident light to the color conversion panel. The incident light may include a blue light, and, optionally, a green light. The blue light may have a peak emission wavelength of about 440 nm to about 460 nm or about 450 nm to about 455 nm.

The light source may include an organic light emitting diode (OLED), a micro LED, a mini LED, an LED including a nanorod, or a combination thereof.

In an embodiment, the electronic device (or display device) includes the color conversion panel or the display panel.

According to an embodiment, it is possible to manufacture a group 11-13-16 compound based semiconductor nanoparticle having improved optical properties (e.g., improved blue light absorption and/or narrow half width and/or increased luminous efficiency) as well as an increased production yield. The color conversion panel or a photoconversion sheet including the semiconductor nanoparticle of an aspect may utilize various light sources, and may be usefully utilized in a liquid crystal display device, a QD OLED display device, and/or a QD micro LED display device in which a QD color conversion layer or pixel is applied to a blue LED, blue-OLED, and/or a blue micro LED, respectively. The semiconductor nanoparticle and the color conversion panel may be applied to various devices such as TVs, monitors, mobile devices, VR/AR, automotive displays, or the like, but embodiments are not limited thereto.

BRIEF DESCRIPTION OF THE DRAWINGS

The above and other aspects, features, and advantages of certain exemplary embodiments will be more apparent from the following detailed description taken in conjunction with the accompanying drawings.

FIG. 1A is a flowchart showing a pattern formation process (photolithography method) using an ink composition of one or more embodiments.

FIG. 1B is a flowchart showing a pattern forming process (inkjet method) using an ink composition of one or more embodiments.

FIG. 2A is a schematic cross-sectional view of a color conversion panel according to one or more embodiments.

FIG. 2B is a cross-sectional view of an electronic device (display device) including a color conversion panel according to one or more embodiments.

FIG. 3A is a perspective view illustrating an example of a display panel including a color conversion panel according to one or more embodiments.

FIG. 3B is an exploded view of a display device according to one or more embodiments.

FIG. 3C is a cross-sectional view of the display panel of FIG. 3A.

FIG. 4 is an exploded view of a display device according to one or more embodiments.

FIG. 5A is a plan view illustrating an example of a pixel arrangement of the display panel of FIG. 3A.

FIGS. 5B, 5C, 5D, and 5E are cross-sectional views showing examples of light emitting devices, respectively, according to one or more embodiments.

FIG. 6 is a cross-sectional view of the display panel of FIG. 5A taken along line IV-IV.

FIG. 7A is a schematic cross-sectional view of a display device (e.g., a liquid crystal display device) according to one or more embodiments.

FIG. 7B is a schematic cross-sectional view of an electronic device (e.g., an electroluminescent device) according to one or more embodiments.

FIG. 8 shows UV-Vis absorption spectra of a 100-fold dilution of the crude solution of Example 1 and a 100-fold dilution of the crude solution of Comparative Example 1.

FIG. 9 shows a UV-Vis absorption spectrum of a 100-fold dilution of the crude solution of Examples 2, 3, and 4.

## DETAILED DESCRIPTION OF THE EMBODIMENTS

Advantages and features of the techniques described hereinafter, and methods of achieving them, will become apparent with reference to the exemplary embodiments described below in further detail in conjunction with the accompanying drawings. However, the embodiments should not be construed as being limited to the exemplary embodiments set forth herein. If not defined otherwise, all terms (including technical and scientific terms) as used herein may be defined as commonly understood by one having ordinary skill in the art. The terms defined in a generally-used dictionary may not be interpreted ideally or exaggeratedly unless clearly defined.

"At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the drawings, the thickness of layers, films, panels, regions, etc., are exaggerated for clarity. Like reference numerals designate like elements throughout the specification.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

As used herein, the singular forms "a," "an," and "the" are intended to include the plural forms, including "at least one," unless the context clearly indicates otherwise. For example, the wording "semiconductor nanoparticle" may refer to a single semiconductor nanoparticle or may refer to a plurality of semiconductor nanoparticles. "At least one" is not to be construed as being limited to "a" or "an." "Or" means "and/or." As used herein, the term "and/or" includes any and all combinations of one or more of the associated listed items.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, 5% of the stated value.

Unless mentioned to the contrary, a numerical range recited herein is inclusive. Unless mentioned to the contrary, a numerical range recited herein includes any real number within the endpoints of the stated range and includes the endpoints thereof. In this specification, a numerical endpoint or an upper or lower limit value (e.g., recited either as a "greater than or equal to value" "at least value" or a "less than or equal to value" or recited with "from" or "to") may be used to form a numerical range of a given feature. In other words, the upper and lower endpoints set forth for various numerical values may be independently combined to provide a range.

As used herein, the expression "not including cadmium (or other harmful heavy metal)" may refer to the case in which a concentration of cadmium (or other harmful heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In one or more embodiments, substantially no amount of cadmium (or other harmful heavy metal) may be present or, if present, an amount of cadmium (or other harmful heavy metal) may be less than or equal to a detection limit or as an impurity level of a given analysis tool.

Hereinafter, as used herein, when a definition is not otherwise provided, "substituted" refers to replacement of at least one hydrogen of a compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group or an amine group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation, a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

In addition, when a definition is not otherwise provided below, "hetero" means a case including 1 to 3 heteroatoms selected from N, O, P, Si, S, Se, Ge, and B.

In addition, the term "aliphatic hydrocarbon group" as used herein refers to a C1 to C30 linear or branched alkyl group, a C2 to C30 linear or branched alkenyl group, or a C2 to C30 linear or branched alkynyl group, and the term "aromatic organic group" as used herein refers to a C6 to C30 aryl group or a C2 to C30 heteroaryl group.

As used herein, the term "(meth)acrylate" refers to acrylate and/or methacrylate.

As used herein, the term "Group" refers to a Group of Periodic Table.

As used herein, the terms "a nanoparticle" and "a nanostructure" refer to a structure having at least one region or characteristic dimension with a nanoscale dimension. In one or more embodiments, the dimension of the nanoparticle or the nanostructure may be less than about 500 nm, less than about 300 nm, less than about 250 nm, less than about 150 nm, less than about 100 nm, less than about 50 nm, or less than about 30 nm. The nanoparticle or nanostructure may have any shape, such as a nanowire, a nanorod, a nanotube, a multi-pod type shape having two or more pods, a nanodot, or the like, but embodiments are not limited thereto. The nanoparticle or nanostructure may be, for example, substantially crystalline, substantially monocrystalline, polycrystalline, amorphous, or a combination thereof.

A quantum dot may be, for example, a semiconductor-containing nanocrystal particle that can exhibit a quantum confinement or exciton confinement effect, and is a type of a luminescent nanostructure (e.g., capable of emitting light by energy excitation). Herein, a shape of the "quantum dot" or the nanoparticle is not limited unless otherwise expressly defined.

As used herein, the term "dispersion" refers to a dispersion in which a dispersed phase is a solid, and a continuous medium includes a liquid or a solid different from the dispersed phase. It is to be understood that the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm and less than several micrometers ($\mu$m) (e.g., less than or equal to about 2 $\mu$m, less than or equal to about 1 $\mu$m, less than or equal to about 900 nm, less than or equal to about 800 nm, less than or equal to about 700 nm, less than or equal to about 600 nm, or less than or equal to about 500 nm).

Herein, a dimension (a size, a diameter, or a thickness, etc.) may be a value for a single entity or an average value for a plurality of nanoparticles. As used herein, the term "average" (e.g., an average size of the quantum dot) may be a mean value or a median value. In one or more embodiments, the average may be "mean" value.

As used herein, the term "peak emission wavelength" is the wavelength at which a given emission spectrum of the light reaches its maximum.

In one or more embodiments, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (i.e., in a composite). In one or more embodiments, the quantum efficiency (or the quantum yield) is the ratio of photons emitted to photons absorbed by the nanostructure or population thereof. In one or more embodiments, the quantum efficiency may be measured by any method. For example, there may be two methods for measuring the fluorescence quantum yield or efficiency: the absolute method and the relative method. The quantum efficiency measured by the absolute method may be referred to as an absolute quantum efficiency.

In the absolute method, the quantum efficiency may be obtained by detecting the fluorescence of all samples through an integrating sphere. In the relative method, the quantum efficiency of the unknown sample may be calculated by comparing the fluorescence intensity of a standard dye (a standard sample) with the fluorescence intensity of the unknown sample. Coumarin 153, Coumarin 545, Rhodamine 101 inner salt, Anthracene and Rhodamine 6G may be used as standard dyes according to their PL wavelengths, but embodiments are not limited thereto.

A full width at half maximum (FWHM) and a maximum emission (e.g., PL: photoluminescence or EL: electroluminescence) wavelength may be measured, for example, from a luminescence spectrum (for example, a photoluminescence spectrum or an electroluminescent spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be included in a variety of electronic devices. An electrical and/or an optical property of the semiconductor nanoparticle may be controlled for example, by the elemental composition of the semiconductor nanoparticle, the size of the semiconductor nanoparticle, and/or the shape of the semiconductor nanoparticle. In one or more embodiments, the semiconductor nanoparticle may be a semiconductor nanocrystal particle. The semiconductor nanoparticle such as a quantum dots may have a relatively large surface area per a unit volume, and thus, may exhibit a quantum confinement effect, exhibiting physical optical properties different from a corresponding bulk material having the same composition. Therefore, a semiconductor nanoparticle such as a quantum dot may absorb energy (e.g., incident light) supplied from an excitation source to form an excited state, which upon relaxation is capable of emitting an energy corresponding to its energy bandgap.

The semiconductor nanoparticle may also be used in a color conversion panel (e.g., a photoluminescent color filter). Instead of a white light-emitting back light unit used in a liquid crystal display device, in a display device including a quantum dot-based color conversion panel or a luminescent type color filter, a quantum dot layer is used as a luminescent material and is disposed in a relatively front part of a display device to convert an incident light (e.g., a blue light) provided from a light source to light of a different spectrum (for example, a green light or a red light). In such a color conversion panel, the color conversion of the excitation light may occur in a relatively front part of the display device, the light may be scattered in all directions, which may address a viewing angle problem of the liquid crystal display device, and a light loss problem caused by using an absorption type color filter may be addressed as well.

As used herein, the term "color conversion panel" refers to an electronic device including a color conversion layer. As used herein, the term "color conversion layer" also includes a structure including a color conversion region (e.g., a color conversion structure).

In the display device including the color conversion panel, properties (e.g., an optical property, stability, or the like) of a luminescent nanostructure may have a direct effect on a displaying quality of the display device. It may be desired for the luminescent material included in the color conversion panel disposed in a relatively front portion of the display device to exhibit not only a relatively high luminescent efficiency but also a relatively high absorbance with respect to an incident light. When a patterned film (e.g., a color filter) is used in the display device, a decreased absorbance to the incident light may be a direct cause of a blue light leakage, having an adversely effect on a color reproducibility (e.g., DCI match rate) of the display device. An adoption of an absorption type color filter for preventing a blue leakage problem may lead to an additional decrease in a luminescent efficiency. Such a lowered absorbance of the semiconductor nanoparticle may result in a reduced luminance in a display device including the same.

Semiconductor nanoparticles may exhibit properties (e.g., optical properties and/or stability) that may be applicable to a display device, but many of them may include a cadmium-based compounds (e.g., a cadmium chalcogenide). The cadmium causes a serious environment/health problem and thus is one of the restricted elements in many countries. Therefore, in order to develop cadmium-free environment-friendly nanoparticles, an in-depth research on nanocrystals based on Group III-V compounds has been conducted. However, there remains a technological need to develop an environmentally friendly nanoparticle that can exhibit a higher absorbance, a narrower the full width at half maximum, and a higher luminescent efficiency in comparison with a cadmium-free nanoparticle based on a Group III-V compound such as an indium phosphide.

In an embodiment, a semiconductor nanoparticle may not include cadmium. In one or more embodiments, the semiconductor nanoparticle may not include mercury, lead, or a combination thereof.

In an embodiment, the semiconductor nanoparticle may include silver, indium, gallium, and sulfur and may have a size or an average size (herein, referred to as "size") of greater than or equal to about 2 nm, or greater than or equal to about 5 nm and less than or equal to about 50 nm, less than or equal to about 10 nm, or less than or equal to about 8 nm.

In an embodiment, the semiconductor nanoparticle may include a first semiconductor nanocrystal including silver, a group 13 element, and a chalcogen element. The first semiconductor nanocrystal may or may not include zinc. The group 13 element may include indium, gallium, or a combination thereof. The chalcogen element may include sulfur and optionally selenium. The first semiconductor nanocrystal may include a quaternary alloy semiconductor material based on a Group 11-13-16 compound including silver (Ag), indium, gallium, and sulfur. The first semiconductor nanocrystal may include silver indium gallium sulfide, e.g., $Ag(In_xGa_{1-x})S_2$ (x is greater than 0 and less than 1). The mole ratios between the components in the first semiconductor nanocrystal may be adjusted so that the final semiconductor nanoparticle may have a desired composition and an optical property (e.g., a maximum emission wavelength).

The semiconductor nanoparticle may further include a second semiconductor nanocrystal, a third semiconductor nanocrystal, or both the second semiconductor nanocrystal and the third semiconductor nanocrystal. The second semiconductor nanocrystal may include gallium, sulfur, and optionally silver, having a composition different from that of the first semiconductor nanocrystal.

The second semiconductor nanocrystal may include a Group 13-16 compound, a Group 11-13-16 compound, or a combination thereof. The Group 13-16 compound may include a gallium sulfide, a gallium selenide, an indium sulfide, an indium selenide, an indium gallium sulfide, an indium gallium selenide, an indium gallium selenide sulfide, or a combination thereof. The second semiconductor nanocrystal may include gallium and a chalcogen element (e.g., sulfur, selenium, or a combination thereof). The second semiconductor nanocrystal may include a ternary alloy semiconductor material containing silver, gallium, and sulfur. The molar ratio between the components in the second semiconductor nanocrystal may be adjusted so that the final semiconductor nanoparticle can exhibit a desired composition and an optical property.

The third semiconductor nanocrystal may include zinc and sulfur. The third semiconductor nanocrystal may include a zinc sulfide.

The second semiconductor nanocrystal may cover at least a portion of the first semiconductor nanocrystal. An energy bandgap of the second semiconductor nanocrystal may be different from that of the first semiconductor nanocrystal. An energy bandgap of the second semiconductor nanocrystal may be greater than an energy bandgap of the first semiconductor nanocrystal. An energy bandgap of the second semiconductor nanocrystal may be less than an energy bandgap of the first semiconductor nanocrystal.

A band gap energy of the third semiconductor nanocrystal may be greater than band gap energy of the second semiconductor nanocrystal. A band gap energy of the third semiconductor nanocrystal may be greater than band gap energy of the first semiconductor nanocrystal. The layer including the third semiconductor nanocrystal may be an outermost layer of the semiconductor nanoparticle.

The semiconductor nanoparticle may have a core shell structure having a core and a shell disposed on the core. The core may include a first semiconductor nanocrystal, and the shell may include a second semiconductor nanocrystal. The shell may be a multilayer shell, and the multilayer shell may include a first shell layer disposed on the core, a second shell layer disposed on the first shell layer, and a third shell layer disposed on the second shell layer. The first shell layer may include a second semiconductor nanocrystal. The second shell layer may include a third semiconductor nanocrystal. The second shell layer or the third shell layer may include a third semiconductor nanocrystal (including a zinc chalcogenide) containing zinc and sulfur.

In an embodiment, the semiconductor nanoparticle may have a core (multilayer) shell structure such as AgInGaS/AgGaS or AgInGaS/AgGaS/ZnS.

In the semiconductor nanoparticle, a concentration of indium may vary or may be different in a radial direction. In the semiconductor nanoparticle, the indium amount of an inner part of the particle may be different from an outer part of the particle. In an embodiment, the indium content in a portion proximate to or adjacent to the surface (e.g., an outermost layer or shell) may be less than the indium content in the inner part (or a core) of the particle above. In an example, the zinc content (concentration) in a portion proximate to or adjacent to the surface (e.g., the outermost layer) of the particle may be greater than the zinc content (concentration) in the inner part (or core) of the particle above. The core or the first semiconductor nanocrystal may not include zinc.

In the shell, gallium may exhibit a concentration gradient that changes (e.g., increases or decreases) in a radial direction. In the shell, the gallium concentration in the portion proximate to or adjacent to the particle surface may be higher than the gallium concentration in the portion proximate to or adjacent to the core.

In an embodiment, a semiconductor nanoparticle containing a group 13 element and a chalcogen element together with silver (Ag) can achieve desired luminescent properties (e.g., increased quantum yield with a reduced full width at half maximum) without including cadmium. According to an embodiment, a semiconductor nanoparticle containing a group 11-13-16 compound can achieve improved optical properties by adjusting the composition (e.g., a charge balance value and/or molar ratios between components as described herein).

Through their research the present inventors initially found that though the semiconductor nanoparticle containing a group 11-13-16 compound could be manufactured to have desired luminescent properties, the manufacturing yield to the semiconductor nanoparticle remained at a relatively low level in accordance with other methods. Without wishing to be bound by any theory, if a semiconductor nanoparticle containing a group 11-13-16 compound and showing a desired luminescent property is to be manufactured according to a known method, for example, a formation process of a second semiconductor nanocrystal containing gallium and sulfur on the first semiconductor nanocrystal can cause a substantial change in the composition and/or size of the first semiconductor nanocrystal that seems difficult to control, and this may cause a significant reduction in the manufacturing yield. Surprisingly, the present inventors have found that a desired semiconductor nanoparticle may be manufactured with a relatively improved production yield, and/or a more consistent nanoparticle size, by using the method described herein.

Accordingly, the method of manufacturing a semiconductor nanoparticle of an embodiment includes obtaining a crude solution containing a semiconductor nanoparticle. The method may include adding a gallium precursor, a sulfur precursor, to a medium (including, for example, an organic solvent and optionally an organic ligand). The method further includes adding a silver compound to the medium. In an embodiment, the method may include adding a first semiconductor nanocrystal including a silver, a group 13 element, and a chalcogen element to the medium. In an embodiment, the medium may already include the semiconductor nanocrystal particle prior to the addition of the gallium precursor, sulfur precursor, and/or the silver compound. The method may include heating the medium to a temperature, for example, to a predetermined temperature, a first temperature or a second temperature (i.e., a reaction temperature). The method may further include adding a non-solvent to the final reaction solution (e.g., after heating) to promote precipitation of the semiconductor nanoparticle thus formed (for example, the semiconductor nanoparticle being coordinated with an organic ligand).

In an embodiment, obtaining the crude solution may involves performing a reaction between the gallium precursor and the sulfur precursor in the presence of the first semiconductor nanocrystal including a silver, a group 13 element, and a chalcogen element and in the presence of the silver compound. The silver compound may participate in the reaction. The medium may be (or act as) a reaction medium for the reaction. Details of the semiconductor nanoparticle and the first semiconductor nanocrystal are the same as described herein.

The method may include conducting a pretreatment for the medium (and, optionally, the sulfur precursor).

In an embodiment, the method may include adding the first semiconductor nanocrystal; and the gallium precursor, the sulfur precursor, or both to the (reaction) medium containing an organic solvent.

The reaction medium may be pre-treated at a pretreatment temperature in a vacuum state before the first semiconductor nanocrystal or the gallium precursor is added. The pretreatment temperature may be lower than the reaction temperature. The pretreatment temperature may be, for example, greater than or equal to about 80°C, greater than or equal to about 100°C, or greater than or equal to about 120°C, and less than or equal to about 200°C, or less than or equal to about 180°C.

The addition manner (e.g., addition order or addition form) of the first semiconductor nanocrystal, the gallium precursor, or the sulfur precursor is not particularly limited. In an embodiment, the first semiconductor nanocrystal and the gallium precursor may be added to the reaction medium containing the sulfur precursor. The first semiconductor nanocrystal may be dispersed in an appropriate organic solvent and added to the reaction medium but is not limited thereto. The gallium precursor may be dispersed in an appropriate organic solvent and added to the reaction medium but is not limited thereto.

The manner for the addition of the silver compound to the (reaction) medium (e.g., addition order or addition form) is also not particularly limited. The silver compound may be added in a state dissolved in a suitable organic solvent (e.g., an amine-based solvent such as oleyl amine, or a phosphine-based solvent such as trioctylphosphine). The addition timing of the silver compound is also not particularly limited and may be appropriately selected. The silver compound may be added to the (reaction) medium before, at the same time with, or after the addition of the first semiconductor nanocrystal, the gallium precursor, and/or the sulfur precursor. In an embodiment, the silver compound may be added to the (reaction) medium after the pretreatment.

Details of the first semiconductor nanocrystal are as the same described herein. The first semiconductor nanocrystal may include silver (Ag), indium, gallium, and sulfur. The method of manufacturing the first semiconductor nanocrystal is not particularly limited and may be appropriately selected. The detailed description about the first semiconductor nanocrystal is as described herein. The first semiconductor nanocrystal may include silver (Ag), indium, gallium, and sulfur. A method of producing the first semiconductor nanocrystal is not particularly limited and may be appropriately selected. In an embodiment, the first semiconductor nanocrystal may be obtained by reacting the required precursors depending on the composition, such as a silver precursor, an indium precursor, a gallium precursor, and a sulfur precursor in a solution including an organic ligand and an organic solvent at a predetermined reaction temperature (e.g., about 180°C to about 300°C or about 200°C to about 280°C), and separating the same. For separation and recovery, a method to be described herein may be referred to.

The predetermined temperature may be greater than or equal to about 120°C, greater than or equal to about 180°C, greater than or equal to about 190°C, greater than or equal to about 200°C, greater than or equal to about 205°C, greater than or equal to about 210°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, greater than or equal to about 345°C. The predetermined temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 320°C, less than or equal to about 310°C, less than or equal to about 300°C, less than or equal to about 295°C, less than or equal to about 290°C, less than or equal to about 280°C, less than or equal to about 270°C, less than or equal to about 260°C, or less than or equal to about 250°C.

The method of an embodiment may include heating the medium (optionally including the sulfur precursor) to a first temperature and adding the first semiconductor nanocrystal, the gallium precursor, the sulfur precursor, or a combination thereof to the medium heated to the first temperature. In the method of an embodiment, the addition of the silver compound may be made at the first temperature, as well.

The method of an embodiment may include heating the medium (e.g., a reaction mixture including the first semiconductor nanocrystal, the gallium precursor, the sulfur precursor, and the silver compound) to a second temperature (e.g., a reaction temperature).

The first temperature may be greater than or equal to about 120°C (e.g., greater than or equal to about 180°C, greater than or equal to about 190°C, or greater than or equal to about 200°C) and less than or equal to about 280°C (e.g., less than or equal to about 250°C), the second temperature may be greater than or equal to about 190°C, or greater than or equal to about 240°C and less than or equal to about 380°C, or less than or equal to about 280°C. The second temperature may be higher than the first temperature. A difference between the first temperature and the second temperature may be greater than or equal to about 10°C, greater than or equal to about 20°C, greater than or equal to about 30°C, greater than or equal to about 40°C, greater than or equal to about 50°C, greater than or equal to about 60°C, greater than or equal to about 70°C, greater than or equal to about 80°C, greater than or equal to about 90°C, or greater than or equal to about 100°C. The difference between the first temperature and the second temperature may be less than or equal to about 200°C, less than or equal to about 190°C, less than or equal to about 180°C, less than or equal to about 170°C, less than or equal to about 160°C, less than or equal to about 150°C, less than or equal to about 140°C, less than or equal to about 130°C, less than or equal to about 120°C, less than or equal to about 110°C, less than or equal to about 100°C, less than or equal to about 90°C, less than or equal to about 80°C, less than or equal to about 70°C, less than or equal to about 60°C, less than or equal to about 50°C, less than or equal to about 40°C, less than or equal to about 30°C, or less than or equal to about 20°C.

The first temperature may be greater than or equal to about 120°C, greater than or equal to about 190°C, greater than or equal to about 200°C, greater than or equal to about 210°C, greater than or equal to about 220°C, greater than or equal to about 230°C, greater than or equal to about 240°C, or greater than or equal to about 250°C. The first temperature may be less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 240°C, less than or equal to about 230°C, less than or equal to about 220°C, less than or equal to about 210°C, less than or equal to about 200°C, less than or equal to about 190°C, less than or equal to about 180°C, less than or equal to about 170°C, less than or equal to about 160°C, or less than or equal to about 150°C.

The second or reaction temperature may be greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The second temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

The reaction time may be controlled so that the resulting semiconductor nanoparticle included in the crude solution may exhibit a charge balance value described herein. In an embodiment, the reaction time may be greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, or greater than or equal to about 80 minutes. The reaction time may be less than or equal to about 3 hours, less than or equal to about 2 hours, or less than or equal to about 90 minutes.

Without wishing to be bound by a specific theory, the presence (e.g., the addition) of a silver compound on a reaction between a gallium precursor and a sulfur precursor in the presence of the first semiconductor nanocrystal can prevent an unwanted change (e.g., interparticle binding or compositional changes) of the first semiconductor nanocrystal, making it possible to provide a greater production yield of semiconductor nanoparticles in the crude solution.

The silver compound may be added to the reaction medium in an amount of greater than or equal to about 0.1 mol% or greater than or equal to about 0.5 mol% relative to the gallium precursor. The added amount of the silver compound may be greater than or equal to about 0.1 mol%, greater than or equal to about 0.5 mol%, greater than or equal to about 1 mol%, greater than or equal to about 2 mol%, greater than or equal to about 3 mol%, greater than or equal to about 4 mol%, greater than or equal to about 5 mol%, greater than or equal to about 6 mol%, greater than or equal to about 7 mol%, greater than or equal to about 8 mol%, greater than or equal to about 9 mol%, greater than or equal to about 10 mol%, greater than or equal to about 11 mol%, greater than or equal to about 12 mol%, greater than or equal to about 13 mol%, greater than or equal to about 14 mol%, greater than or equal to about or 15 mol%, based on the gallium precursor. The content of the silver compound may be less than or equal to about 50 mol%, less than or equal to about 30 mol%, less than or equal to about 25 mol%, less than or equal to about 20 mol%, less than or equal to about 18 mol%, less than or equal to about 17 mol%, less than or equal to about 15 mol%, less than or equal to about 14 mol%, less than or equal to about 13 mol%, less than or equal to about 12 mol%, less than or equal to about 11 mol%, less than or equal to about 9 mol%, less than or equal to about 8 mol%, less than or equal to about 6 mol%, less than or equal to about 5 mol%, less than or equal to about 4 mol%, less than or equal to about 3 mol%, or less than or equal to about 2 mol%, based on the gallium precursor. For example, the amount of the silver compound may be greater than or equal to about 0.1 mol% and less than or equal to about 25 mol%, greater than or equal to about 1 mol% and less than or equal to about 20 mol%, greater than or equal to about 2 mol% and less than or equal to about 12 mol%, greater than or equal to about 3 mol% and less than or equal to about 11 mol%, or greater than or equal to about 4 mol% and less than or equal to about 10.5 mol%.

The silver compound may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver compound may include a silver nitrate, a silver acetate, a silver acetylacetonate, a silver chloride, a silver bromide, a silver fluoride, or a combination thereof.

The method can produce semiconductor nanoparticles exhibiting desired optical properties with an increased production yield. In an embodiment, as measured with the crude solution being diluted 100 times with toluene, the optical density thereof defined by the following equation at a wavelength of 500 nm may be greater than or equal to about 1 and less than or equal to about 10:

$$\text{Optical density} = \log_{10}(I_O/I_T)$$

$I_O$ = an intensity of incident light supplied to the solution (for example, provided to the crude solution)
$I_T$ = intensity of transmitted light passing through the solution.

The optical density is a parameter that is related to absorbance and may be used to quantify a concentration of solutes or nanoparticles, for example, in a medium. According to Beer-Lambert's law, the absorbance may be proportional to a concentration and an extinction coefficient of solutes (e.g., semiconductor nanoparticle) in a given solution.

The optical density may be the optical attenuation per centimeter of material as measured using a standard spectrometer, for example with a 1 cm optical path length. In a solution including semiconductor nanoparticles, the molar concentration of the semiconductor nanoparticles may be related with the optical density.

The optical density of the semiconductor nanoparticle-containing crude solution may be easily and reproducibly measured using a (e.g., commercially available) UV-Vis spectrometer. For example, in order to measure the optical density, the obtained crude solution may be diluted 100-fold with an organic solvent (e.g., toluene) and may be measured by multiplying the absorbance (optical path length 10 mm) value obtained from the UV-Vis spectrometer by 100 again.

In their research the present inventors found that a crude solution obtained according to the method known in the prior art exhibits a relatively low level of optical density, for example, at a wavelength of 500 nm, and such a low level of optical density may suggest that the number of semiconductor nanoparticles actually produced in the reaction system is relatively low. Surprisingly, the present inventors have found that by the method of an embodiment described herein, a crude solution thus obtained can exhibit a significantly increased optical density, for example, at least two times (2X) or more, or approximately nine times or more than the prior methods of preparation in the prior art. In addition, the semiconductor nanoparticle contained in the obtained crude solution can exhibit an improved level of quantum efficiency (e.g., 60% or more, or 70% or more) as described herein.

According to the method of an embodiment, an optical density at a wavelength of 500 nm may be greater than or equal to about 1, greater than or equal to about 1.1, greater than or equal to about 1.3, greater than or equal to about 1.4, greater than or equal to about 1.5, greater than or equal to about 1.6, greater than or equal to about 1.7, greater than or equal to about 1.8, greater than or equal to about 1.9, greater than or equal to about 2, greater than or equal to about 2.1, greater than or equal to about 2.2, greater than or equal to about 2.3, greater than or equal to about 2.4, greater than or equal to about 2.5, greater than or equal to about 2.6, greater than or equal to about 2.7, greater than or equal to about 2.8, greater than or equal to about 2.9, greater than or equal to about 3, or greater than or equal to about 3.5. The optical density at a wavelength of 500 nm may be less than or equal to about 10, less than or equal to about 7, less than or equal to about 5, less than or equal to about 4.5, less than or equal to about 4, less than or equal to about 3.5, less than or equal to about 3, or less than or equal to about 2.8.

In an embodiment, the crude solution may have an optical density at a wavelength of 350 nm that is greater than or equal to about 8, greater than or equal to about 8.5, greater than or equal to about 9, greater than or equal to about 9.5, greater than or equal to about 10, greater than or equal to about 10.5, greater than or equal to about 11, greater than or equal to about 11.5, greater than or equal to about 12, greater than or equal to about 12.5, greater than or equal to about 13, greater than or equal to about 13.5, greater than or equal to about 14, greater than or equal to about 14.5, greater than or equal to about 15, greater than or equal to about 15.3, greater than or equal to about 16, greater than or equal to about 16.5, greater than or equal to about 17, greater than or equal to about 17.5, greater than or equal to about 18, greater than or equal to about 18.5, greater than or equal to about 19, greater than or equal to about 19.5, greater than or equal to about 20, greater than or equal to about 20.5, greater than or equal to about 21, greater than or equal to about 23, or greater than or equal to about 25. The optical density at a wavelength of 350 nm may be less than or equal to about 100, less than or equal to about 80, less than or equal to about 60, less than or equal to about 40, or less than or equal to about 35. The optical density at a wavelength of 350 nm may be greater than or equal to about 12 and less than or equal to about 50.

In the UV-Vis absorption spectrum, the crude solution may exhibit a ratio of absorbance at a wavelength of 500 nm to absorbance at 350 nm (i.e. an absorption ratio of $A_{500}:A_{350}$) that is greater than or equal to about 0.01:1, greater than or equal to about 0.02:1, greater than or equal to about 0.03:1, greater than or equal to about 0.04:1, greater than or equal to about 0.05:1, greater than or equal to about 0.06:1, greater than or equal to about 0.07:1, greater than or equal to about 0.08:1, greater than or equal to about 0.09:1, greater than or equal to about 0.1:1, greater than or equal to about 0.12:1, greater than or equal to about 0.13:1, greater than or equal to about 0.15:1, greater than or equal to about 0.16:1, greater than or equal to about 0.17:1, or greater than or equal to about 0.18:1. The absorption ratio of $A_{500}:A_{350}$ may be less than or equal to about 0.8:1, less than or equal to about 0.5:1, less than or equal to about 0.3:1, less than or equal to about 0.2:1, less than or equal to about 0.15:1, or less than or equal to about 0.14:1.

In an embodiment, the method may exhibit a production yield determined by the following equation that is greater than or equal to about 6%:

$$\text{Production yield (\%)} = A/B \times 100$$

A: a total weight of silver, a Group 13 element, sulfur among the semiconductor nanoparticles recovered from the crude solution; and

B: a total weight of silver, a Group 13 element, and sulfur added (e.g., supplied) to the reaction medium for the reaction.

The production yield may be greater than or equal to about 6%, greater than or equal to about 7%, greater than or equal to about 8%, greater than or equal to about 9%, greater than or equal to about 10%, greater than or equal to about 11%, greater than or equal to about 12%, greater than or equal to about 13%, greater than or equal to about 14%, greater than or equal to about 15%, greater than or equal to about 16%, greater than or equal to about 17%, greater than or equal to about 18%, greater than or equal to about 19%, greater than or equal to about 20%, greater than or equal to about 21%, greater than or equal to about 22%, greater than or equal to about 23%, greater than or equal to about 24%, or greater than or equal to about 25%. The production yield may be less than or equal to about 100%, less than or equal to about 90%, less than or equal to about 80%, less than or equal to about 70%, or less than or equal to about 60%.

The method may further include preparing an additional reaction medium (e.g., solution) that includes a zinc precursor and optionally an organic ligand in an organic solvent; adding the formed semiconductor nanoparticle and a chalcogen precursor to the reaction medium and heating the medium to a temperature to provide a third semiconductor nanocrystal including zinc chalcogenide or an outer layer including the third semiconductor nanocrystal for example on a surface of the semiconductor nanoparticle thus formed. The third semiconductor nanocrystal may have a composition different from that of the first semiconductor nanocrystal and the second semiconductor nanocrystal.

In an embodiment, a reaction temperature for forming the third semiconductor nanocrystal (or the zinc chalcogenide) may be greater than or equal to about 120°C, greater than or equal to about 130°C, greater than or equal to about 150°C, greater than or equal to about 180°C, greater than or equal to about 200°C, greater than or equal to about 205°C, greater than or equal to about 208°C, and less than or equal to about 240°C, less than or equal to about 230°C, less than or equal to about 225°C, less than or equal to about 215°C. The time for the reaction for forming the third semiconductor nanocrystal (or the zinc chalcogenide) may be greater than or equal to about 10 minutes, greater than or equal to about 30 minutes, greater than or equal to about 40 minutes, greater than or equal to about 1 hour, greater than or equal to about 80 minutes, greater than or equal to about 90 minutes and less than or equal to about 5 hours, less than or equal to about 4 hours, less than or equal to about 3 hours, less than or equal to about 2 hours, less than or equal to about 90 minutes , or less than or equal to about 70 minutes.

In the method of an embodiment, an addition manner of a reagent (the precursors, the semiconductor nanocrystal, the semiconductor nanoparticle, or the like) is not particularly limited but may be selected appropriately. it may include a shot addition (e.g., syringe addition), a dropwise addition, or a combination of the two different types of addition.

A type of the silver precursor is not particularly limited, and may be selected appropriately. The silver precursor may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver precursor may include a silver nitrate, a silver acetate, a silver acetylacetonate, or a combination thereof.

A type of the indium precursor is not particularly limited and may be selected appropriately. The indium precursor may include an indium powder, an alkylated indium compound, an indium alkoxide, an indium carboxylate, an indium nitrate, an indium perchlorate, an indium sulfate, an indium acetylacetonate, an indium halide, an indium cyanide, an indium hydroxide, an indium oxide, an indium peroxide, an indium carbonate, or a combination thereof. The indium precursor may include an indium carboxylate such as indium oleate and indium myristate, an indium acetate, an indium hydroxide, indium chloride, indium bromide, indium iodide, or a combination thereof.

A type of the gallium precursor is not particularly limited and may be appropriately selected. The gallium precursor may include a gallium powder, an alkylated gallium compound, a gallium alkoxide, a gallium carboxylate, a gallium nitrate, a gallium perchlorate, a gallium sulfate, a gallium acetylacetonate, a gallium halide, a gallium cyanide, a gallium hydroxide, a gallium oxide, a gallium peroxide, a gallium carbonate, or a combination thereof. The gallium precursor may include gallium chloride, gallium iodide, gallium bromide, gallium acetate, gallium acetylacetonate, gallium oleate, gallium palmitate, gallium stearate, gallium myristate, gallium hydroxide, or a combination thereof.

A type of the sulfur precursor is not particularly limited and may be appropriately selected. The sulfur precursor may be an organic solvent dispersion or a reaction product of sulfur and an organic solvent (for example, a octadecene sulfide (S-ODE), a trioctylphosphine sulfide (S-TOP), a tributylphosphine sulfide (S-TBP), a triphenylphosphine-sulfide (S-TPP), a trioctylamine sulfide (S-TOA)), a trimethylsilylalkyl sulfide, a trimethylsilyl sulfide, a mercapto propyl silane, an ammonium sulfide, a sodium sulfide, a C1-30 thiol compound (e.g., α-toluene thiol, octane thiol, dodecanethiol, octadecene thiol, or the like), an isothiocyanate compound (e.g., cyclohexylisothiocyanate, or the like), alkylenetrithiocarbonate (e.g., ethylene trithiocarbonate or the like), allyl mercaptan, a thiourea compound (e.g., dialkylthiourea having a C1 to C40 alkyl group such as dimethylthiourea, diethyl thiourea, ethyl methyl thiourea, dipropyl thiourea, or the like), or a combination thereof.

The selenium precursor, if present, may include selenium-trioctylphosphine (Se-TOP), selenium-tributylphosphine (Se-TBP), selenium-triphenylphosphine (Se-TPP), or a combination thereof.

A type of the zinc precursor is not particularly limited and may be appropriately selected. In one or more embodiments, the zinc precursor may include a Zn metal powder, an alkylated Zn compound, a Zn alkoxide, a Zn carboxylate, a Zn nitrate, a Zn perchlorate, a Zn sulfate, a Zn acetylacetonate, a Zn halide, a Zn cyanide, a Zn hydroxide, a Zn oxide, a Zn peroxide, or a combination thereof. The zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof. In an embodiment, when the third semiconductor nanocrystal containing zinc and sulfur is formed, the zinc precursor may include Zn halide, but is not limited thereto.

The organic ligand may include $RCOOH$, $RNH_2$, $R_2NH$, $R_3N$, $RSH$, $RH_2PO$, $R_2HPO$, $R_3PO$, $RH_2P$, $R_2HP$, $R_3P$, $ROH$, $RCOOR'$, $RPO(OH)_2$, $RHPOOH$, $R_2POOH$ (wherein, R and R' are each independently substituted or unsubstituted C1 to C40 (or C3 to C24) aliphatic hydrocarbon group (e.g., an alkyl group, an alkenyl group, or an alkynyl group), or a substituted or unsubstituted C6 to C40 (or C6 to C24) aromatic hydrocarbon group (e.g., a C6 to C20 aryl group)), or a combination thereof. The organic ligand may be bound to the surface of the semiconductor nanoparticle. Examples of the organic ligand may include methane thiol, ethane thiol, propane thiol, butane thiol, pentane thiol, hexane thiol, heptane thiol, octane thiol, 1-nonanethiol, decanethiol, dodecane thiol, hexadecane thiol, octadecane thiol, benzyl thiol; methyl amine, ethyl amine, propyl amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methyl phosphine (e.g., trimethyl phosphine, methyldiphenyl phosphine, or the like), substituted or unsubstituted ethyl phosphine (e.g., triethyl phosphine, ethyldiphenyl phosphine, or the like), substituted or unsubstituted propyl phosphine, substituted or unsubstituted butyl phosphine, substituted or unsubstituted pentyl phosphine, substituted or unsubstituted octylphosphine (e.g., trioctylphosphine (TOP) or the like); a phosphine oxide such as substituted or unsubstituted methyl phosphine oxide (e.g., trimethyl phosphine oxide, methyldiphenyl phosphine oxide, or the like), substituted or unsubstituted ethyl phosphine oxide (e.g., triethyl phosphine oxide, ethyldiphenyl phosphine oxide, or the like), substituted or unsubstituted propyl phosphine oxide, substituted or unsubstituted butyl phosphine oxide, substituted or unsubstituted octylphosphine oxide (e.g., trioctylphosphine oxide (TOPO), or the like); diphenyl phosphine, a triphenyl phosphine, or an oxide compound thereof; phosphonic acid, e.g., a C5 to C20 alkyl phosphonic acid, a C5 to C20 alkylphosphinic acid such as hexylphosphinic acid, octylphosphinic acid, dodecanephosphinic acid, tetradecanephosphinic acid, hexadecanephosphinic acid, octadecanephosphinic acid, or the like; or the like, but embodiments are not limited thereto. The organic ligand may be used alone or as a mixture of two or more.

The organic solvent may include an amine solvent (e.g., a C1-50 aliphatic amine), a nitrogen-containing heterocyclic compound such as pyridine; a C6 to C40 aliphatic hydrocarbon (e.g., alkane, alkene, alkyne, or the like) such as hexadecane, octadecane, octadecene, squalene, or the like; a C6 to C30 aromatic hydrocarbon such as phenyldodecane, phenyltetradecane, phenyl hexadecane, or the like; a phosphine substituted with a C6 to C22 alkyl group such as trioctylphosphine or the like; a phosphine oxide substituted with a C6 to C22 alkyl group such as trioctylphosphine oxide, or the like; a C12 to C22 aromatic ether such as a phenyl ether, a benzyl ether, or the like; or a combination thereof. The amine solvent may be a compound having one or more (e.g., two or three) C1-50, C2-45, C3-40, C4-35, C5-30, C6-25, C7-20, C8-15, or C6-22 aliphatic hydrocarbon groups (e.g., alkyl group, alkenyl group, or alkynyl group). In one or more embodiments, the amine solvent may be a C6-22 primary amine such as hexadecyl amine, oleylamine, or the like; a C6-22 secondary amine such as dioctyl amine or the like; a C6-22 tertiary amine such as trioctylamine or the like; or a combination thereof.

Amounts of the organic ligand and the precursors in the reaction medium may be selected appropriately in consideration of the type of solvent, the type of the organic ligand and each precursor, and the size and composition of desired semiconductor nanoparticles. Mole ratios between the precursors may be changed taking into consideration the desired mole ratios in the final semiconductor nanoparticle, the reactivities among the precursors, or the like. For example, in the preparation of the first semiconductor nanocrystal, a mole ratio of the silver precursor relative to indium precursor may be within 0.5:1 to 1.2:1, but is not limited thereto. In an embodiment, a manner of adding each of the precursors is not particularly limited. In one or more embodiments, a total or complete amount of a precursor may be added at one time. In an embodiment, a total amount of a precursor may be divided and added into greater than or equal to about 2 aliquots and less than or equal to about 10 aliquots. The precursors may be added simultaneously or sequentially in a predetermined order. The reaction may be carried out in an inert gas atmosphere, in air, or in a vacuum state, but is not limited thereto.

When a nonsolvent is added to the final reaction solution after completion of the reaction, (e.g., the organic ligand is coordinated) nanoparticles or nanocrystal may be separated (e.g., precipitated). The nonsolvent may be a polar solvent that is miscible with the solvent used in the reaction but cannot disperse the nanocrystals. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated nanocrystals may be washed by adding to a washing solvent as needed. The washing solvent is not particularly limited, and a solvent having a solubility parameter similar to that of the organic solvent or ligand may be used. The nonsolvent or washing solvent may be alcohols; alkane solvents such as hexane, heptane, octane, or the like; aromatic solvents such as toluene, benzene, or the like; halogenated solvent such as chloroform or the like; or a combination thereof but is not limited thereto.

The semiconductor nanoparticle thus prepared may be dispersed in a dispersion solvent. The semiconductor nanoparticle thus prepared may form an organic solvent dispersion. The organic solvent dispersion may not include water and/or an organic solvent miscible with water. The dispersion solvent may be appropriately selected. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

In an embodiment, the semiconductor nanoparticle may include or may not contain lithium. The semiconductor nanoparticles may include or may not contain alkali metals such as sodium, potassium, or the like.

In the semiconductor nanoparticle, a mole ratio of gallium to indium (Ga:In) may be greater than or equal to about 1:1, greater than or equal to about 1.5:1, greater than or equal to about 2:1, greater than or equal to about 2.5:1, greater than or equal to about 3:1, greater than or equal to about 3.1:1, greater than or equal to about 3.3:1, greater than or equal to about 3.4:1, greater than or equal to about 3.5:1, greater than or equal to about 3.6:1, greater than or equal to about 3.7:1, greater than or equal to about 3.8:1, greater than or equal to about 3.9:1, greater than or equal to about 4:1, greater than or equal to about 4.1:1, greater than or equal to about 4.2:1, greater than or equal to about 4.3:1, greater than or equal to about 4.4:1, greater than or equal to about 4.5:1, greater than or equal to about 4.6:1, or greater than or equal to about 4.7:1; less than or equal to about 10:1, less than or equal to about 9:1, less than or equal to about 8.5:1, less than or equal to about 8:1, less than or equal to about 6.5:1, less than or equal to about 6:1, less than or equal to about 5.5:1, less than or equal to about 5.3:1, less than or equal to about 5.1:1, less than or equal to about 5:1, less than or equal to about 4.9:1, less than or equal to about 4.7:1, less than or equal to about 4.5:1, less than or equal to about 4.3:1, less than or equal to about 4.2:1, less than or equal to about 4.1:1, less than or equal to about 4:1, less than or equal to about 3.9:1, less than or equal to about 3.8:1, less than or equal to about 3.7:1, less than or equal to about 3.6:1, or less than or equal to about 3.55:1; or a combination thereof.

In the semiconductor nanoparticle, a mole ratio of gallium to a sum of indium and gallium (Ga:(In+Ga)) may be greater than or equal to about 0.70:1, greater than or equal to about 0.715:1, greater than or equal to about 0.72:1, greater than or equal to about 0.725:1, greater than or equal to about 0.73:1, greater than or equal to about 0.735:1, greater than or equal to about 0.74:1, greater than or equal to about 0.745:1, greater than or equal to about 0.75:1, greater than or equal to about 0.755:1, greater than or equal to about 0.76:1, greater than or equal to about 0.765:1, greater than or equal to about 0.77:1, greater than or equal to about 0.775:1, greater than or equal to about 0.78:1, greater than or equal to about 0.785:1, greater than or equal to about 0.79:1, or greater than or equal to about 0.795:1, greater than or equal to about 0.8:1, greater than or equal to about 0.805:1, greater than or equal to about 0.81:1, greater than or equal to about 0.815:1, greater than or equal to about 0.82:1, or greater than or equal to about 0.825:1; less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, less than or equal to about 0.91:1, less than or equal to about 0.9:1, less than or equal to about 0.87:1, less than or equal to about 0.85:1, less than or equal to about 0.845:1, less than or equal to about 0.84:1, less than or equal to about 0.835:1, less than or equal to about 0.83:1, less than or equal to about 0.825:1, less than or equal to about 0.82:1, less than or equal to about 0.815:1, less than or equal to about 0.81:1, less than or equal to about 0.805:1, less than or equal to about 0.8:1, less than or equal to about 0.795:1, less than or equal to about 0.79:1, less than or equal to about 0.785:1, less than or equal to about 0.78:1, less than or equal to about 0.775:1, or less than or equal to about 0.77:1; or a combination thereof.

In the semiconductor nanoparticle, a mole ratio of gallium to silver (Ga:Ag) may be greater than or equal to about 1:1, greater than or equal to about 1.1:1, greater than or equal to about 1.15:1, greater than or equal to about 1.2:1, greater than or equal to about 1.22:1, greater than or equal to about 1.3:1, greater than or equal to about 1.33:1, greater than or equal to about 1.34:1, greater than or equal to about 1.35:1, greater than or equal to about 1.36:1, greater than or equal to about 1.4:1, greater than or equal to about 1.46:1, greater than or equal to about 1.48:1, greater than or equal to about 1.5:1, greater than or equal to about 1.54:1, greater than or equal to about 1.6:1, or greater than or equal to about 1.65:1; less than or equal to about 3:1, less than or equal to about 2.9:1, less than or equal to about 2.8:1, less than or equal to about 2.75:1, less than or equal to about 2.5:1, less than or equal to about 2.2:1, less than or equal to about 2:1, less than or equal to about 1.9:1, less than or equal to about 1.8:1, less than or equal to about 1.75:1, less than or equal to about 1.7:1, less than or equal to about 1.65:1, less than or equal to about 1.6:1, less than or equal to about 1.58:1, less than or equal to about 1.55:1, less than or equal to about 1.5:1, less than or equal to about 1.45:1, less than or equal to about 1.4:1, or less than or equal to about 1.35:1; or a combination thereof.

In the semiconductor nanoparticle, a mole ratio of gallium to a sum of gallium, indium, and silver (Ga:(Ga+In+Ag)) may be greater than or equal to about 0.45:1, greater than or equal to about 0.46:1, greater than or equal to about 0.47:1, greater than or equal to about 0.48:1, greater than or equal to about 0.49:1, greater than or equal to about 0.5:1, greater than or equal to about 0.51:1, greater than or equal to about 0.52:1, or greater than or equal to about 0.53:1; less than or equal to about 0.65:1, less than or equal to about 0.6:1, less than or equal to about 0.57:1, less than or equal to about 0.54:1, less than or equal to about 0.53:1, less than or equal to about 0.52:1, less than or equal to about 0.51:1, less than or equal to about 0.5:1, less than or equal to about 0.49:1, or less than or equal to about 0.485:1; or a combination thereof.

In the semiconductor nanoparticle, a mole ratio of a sum of indium and gallium to silver ((In+Ga):Ag) may be greater than or equal to about 1.2:1, greater than or equal to about 1.3:1, greater than or equal to about 1.4:1, greater than or equal to about 1.45:1, greater than or equal to about 1.46:1, greater than or equal to about 1.5:1, greater than or equal to about 1.63:1, greater than or equal to about 1.7:1, greater than or equal to about 1.83:1, greater than or equal to about 1.9:1, greater than or equal to about 1.94:1, or greater than or equal to about 2:1; less than or equal to about 3.7:1, less than or equal to about 3.5:1, less than or equal to about 3:1, less than or equal to about 2.4:1, less than or equal to about 2.37:1, less than or equal to about 2:1, less than or equal to about 1.96:1, less than or equal to about 1.95:1, or less than or equal to about 1.9:1; or a combination thereof.

In the semiconductor nanoparticle, a mole ratio of silver to sulfur (Ag:S) may be greater than or equal to about 0.05:1, greater than or equal to about 0.15:1, greater than or equal to about 0.2:1, greater than or equal to about 0.23:1, greater than or equal to about 0.25:1, greater than or equal to about 0.28:1, greater than or equal to about 0.3:1, greater than or equal to about 0.31:1, greater than or equal to about 0.32:1, greater than or equal to about 0.33:1, or greater than or equal to about 0.35:1; less than or equal to about 0.5:1, less than or equal to about 0.45:1, less than or equal to about 0.41:1, less than or equal to about 0.4:1, less than or equal to about 0.36:1, less than or equal to about 0.35:1, or less than or equal to about 0.33:1; or a combination thereof.

In the semiconductor nanoparticle, a mole ratio of silver to indium (Ag:In) may be greater than or equal to about 1.5:1, greater than or equal to about 2:1, greater than or equal to about 2.25:1, greater than or equal to about 2.3:1, greater than or equal to about 2.37:1, greater than or equal to about 2.4:1, greater than or equal to about 2.5:1, greater than or equal to about 2.51:1, greater than or equal to about 2.6:1, greater than or equal to about 2.65:1, greater than or equal to about 2.7:1, greater than or equal to about 2.9:1, greater than or equal to about 3:1, or greater than or equal to about 3.1:1; less than or equal to about 6:1, less than or equal to about 5.5:1, less than or equal to about 5.2:1, less than or equal to about 5:1, less than or equal to about 4.5:1, less than or equal to about 4.4:1, less than or equal to about 4:1, less than or equal to about 3.9:1, less than or equal to about 3.8:1, less than or equal to about 3.7:1, or less than or equal to about 3.6:1, or less than or equal to about 3:1; or a combination thereof.

In the semiconductor nanoparticle, a mole ratio of sulfur to indium (S:In) may be greater than or equal to about 6:1, greater than or equal to about 6.5:1, greater than or equal to about 7.5:1, greater than or equal to about 7.7:1, greater than or equal to about 7.8:1, greater than or equal to about 8:1, greater than or equal to about 8.9:1, greater than or equal to about 9:1, greater than or equal to about 9.8:1, or greater than or equal to about 10:1; less than or equal to about 25:1, less than or equal to about 20:1, less than or equal to about 19:1, or less than or equal to about 18:1; or a combination thereof.

In the semiconductor nanoparticle, a mole ratio of silver to a sum of silver, indium, and gallium (Ag:(Ag+In+Ga)) may be greater than or equal to about 0.2:1, greater than or equal to about 0.25:1, greater than or equal to about 0.3:1, greater than or equal to about 0.33:1, greater than or equal to about 0.34:1, greater than or equal to about 0.35:1, greater than or equal to about 0.37:1, or greater than or equal to about 0.4:1; less than or equal to about 0.45:1, less than or equal to about 0.41:1, less than or equal to about 0.4:1, less than or equal to about 0.36:1, less than or equal to about 0.33:1, less than or equal to about 0.32:1, less than or equal to about 0.28:1; or a combination thereof.

In the semiconductor nanoparticle, a mole ratio of sulfur to a sum of silver, indium, and gallium (S:(Ag+In+Ga)) may be greater than or equal to about 0.8:1, greater than or equal to about 0.9:1, greater than or equal to about 1:1, greater than or equal to about 1.05:1, greater than or equal to about 1.12:1, or greater than or equal to about 1.3:1; less than or equal to about 1.5:1, less than or equal to about 1.45:1, less than or equal to about 1.35:1, less than or equal to about 1.3:1, less than or equal to about 1.15:1, or less than or equal to about 1.13:1, or less than or equal to about 1.08:1; or a combination thereof.

In the semiconductor nanoparticle, a mole ratio of gallium to sulfur (Ga:S) may be greater than or equal to about 0.4:1, greater than or equal to about 0.44:1, greater than or equal to about 0.48:1, greater than or equal to about 0.5:1, or greater than or equal to about 0.55:1; less than or equal to about 0.6:1, less than or equal to about 0.56:1, or less than or equal to about 0.51:1; or a combination thereof.

In an embodiment, the semiconductor nanoparticle may have a charge balance value that is greater than or equal to about 0.8, greater than or equal to about 0.85, greater than or equal to about 0.9, greater than or equal to about 0.91, greater than or equal to about 0.92, greater than or equal to about 0.93, greater than or equal to about 0.95, greater than or equal to about 0.98, greater than or equal to about 0.99, greater than or equal to about 1.02, or greater than or equal to about 1.06:1; less than or equal to about 1.4, less than or equal to about 1.35, less than or equal to about 1.3, less than or equal to about 1.25, less than or equal to about 1.2, less than or equal to about 1.18, less than or equal to about 1.17, less than or equal to about 1.15, less than or equal to about 1.1, less than or equal to about 1.05, or less than or equal to about 1; or a combination thereof:

$$\text{charge balance value} = \{[Ag] + 3([In]+[Ga])\}/(2[S])$$

wherein, in the above equation, [Ag], [In], [Ga], and [S] are molar amounts of silver, indium, gallium, and sulfur in the semiconductor nanoparticle, respectively.

A size (or an average size, hereinafter, can be simply referred to as "size") of the first semiconductor nanocrystal may be greater than or equal to about 0.5 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, greater than or equal to about 3.9 nm, greater than or equal to about 4 nm, or greater than or equal to about 4.2 nm. The size of the first semiconductor nanocrystal may be less than or equal to about 6 nm, less than or equal to about 5.5 nm, less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

A thickness (or an average thickness, hereinafter, simply referred to as "thickness") of the second semiconductor nanocrystal or a layer including the same may be greater than or equal to about 0.1 nm, greater than or equal to about 0.2 nm, or greater than or equal to about 0.3 nm. The thickness of the second semiconductor nanocrystal or a layer including the same may be less than or equal to about 3 nm, less than or equal to about 2.5 nm, less than or equal to about 2 nm, less than or equal to about 1.5 nm, less than or equal to about 1 nm, or less than or equal to about 0.8 nm.

The thickness of the third semiconductor nanocrystal or the layer including the third semiconductor nanocrystal may be greater than or equal to about 0.1 nm, greater than or equal to about 0.3 nm, greater than or equal to about 0.5 nm, greater than or equal to about 0.7 nm, or greater than or equal to about 1 nm. The thickness of the third semiconductor nanocrystal or the layer including the same may be less than or equal to about 2 nm, less than or equal to about 1.5 nm, less than or equal to about 1 nm, or less than or equal to about 0.8 nm. The thickness of the third semiconductor nanocrystal or the layer including the same may be from about 0.1 nm to about 5 nm, from about 0.2 nm to about 4 nm, from about 0.3 nm to about 3.5 nm, from about 0.4 nm to about 3 nm, from about 0.5 nm to about 2.5 nm, about 0.6 nm - about 2 nm, about 0.7 nm - about 1.5 nm, about 0.8 nm - about 1.2 nm, about 0.9 nm - about 1 nm, or a combination thereof.

A size or an average size (hereinafter, simply referred to as "size") of the semiconductor nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to about 11 nm, less than or equal to about 10 nm, less than or equal to about 8 nm, less than or equal to about 7.5 nm, less than or equal to about 6 nm, or less than or equal to about 4 nm.

As used herein, the size of the semiconductor nanoparticle may be a particle diameter. The size of the semiconductor nanoparticle may be an equivalent diameter thereof that is obtained by a calculation involving a conversion of a two-dimensional area of a transmission electron microscopy image of a given particle into a circle. The size of the semiconductor nanoparticles can be obtained from images obtained by an electron microscope (e.g., transmission electron microscope) analysis. Such a particle size can be measured reproducibly and easily using various image processing programs (e.g., in-house programs that can be made using image J or coding languages) from microscopic images. The particle size may be a value (e.g., a nominal particle size) calculated from a composition and a peak emission wavelength of the semiconductor nanoparticle.

The semiconductor nanoparticle may have a size or an average size of 5 nm or more, 5.1 nm or more, 5.2 nm or more, and 10 nm or less, 7 nm or less, 6.5 nm or less, 6 nm or less, or 5.4 nm or less. The semiconductor nanoparticle may exhibit a size distribution represented by a standard deviation of 20% or less, 19% or less, 18% or less, 17% or less, 16% or less, 15% or less, 14% or less, 13% or less, 12% or less, 11% or less, or 10% or less of the average size. The standard deviation may be 5% or more, 10% or more, or 12% or more of the average size.

The semiconductor nanoparticles may be configured to emit green light. The peak emission wavelength of the green light may be greater than or equal to about 500 nm, or greater than or equal to about 505 nm and less than or equal to about 580 nm, or less than or equal to about 550 nm.

A peak emission wavelength of the green light or a peak emission wavelength of the semiconductor nanoparticle may be greater than or equal to about 500 nm, greater than or equal to about 505 nm, greater than or equal to about 510 nm, greater than or equal to about 515 nm, greater than or equal to about 520 nm, greater than or equal to about 525 nm, greater than or equal to about 530 nm, greater than or equal to about 535 nm, greater than or equal to about 540 nm, or greater than or equal to about 545 nm. The peak emission wavelength of the green light or the peak emission wavelength of the semiconductor nanoparticle may be less than or equal to about 580 nm, less than or equal to about 575 nm, less than or equal to about 570 nm, less than or equal to about 565 nm, less than or equal to about 560 nm, less than or equal to about 555 nm, less than or equal to about 550 nm, less than or equal to about 545 nm, less than or equal to about 540 nm, less than or equal to about 535 nm, less than or equal to about 530 nm, less than or equal to about 525 nm, less than or equal to about 520 nm, or less than or equal to about 515 nm.

The semiconductor nanoparticles may be configured to emit red light. The peak emission wavelength of the red light or the peak emission wavelength of the semiconductor nanoparticle may range from 600 nm to 660 nm, 605 nm to 650 nm, 610 nm to 645 nm, 615 nm to 640 nm, 620 nm to 635 nm, 623 nm to 632 nm, 625 nm to 630 nm, 628 nm to 629 nm, or a combination thereof.

The semiconductor nanoparticle may exhibit a quantum yield of greater than or equal to about 50%. The quantum yield may be an absolute quantum yield. The quantum yield may be greater than or equal to about 50%, greater than or equal to about 55%, greater than or equal to about 60%, greater than or equal to about 65%, greater than or equal to about 70%, greater than or equal to about 75%, greater than or equal to about 80%, greater than or equal to about 85%, greater than or equal to about 90%, or greater than or equal to about 95%. The quantum yield may be less than or equal to about 100%, less than or equal to about 99.5%, less than or equal to about 99%, less than or equal to about 98%, or less than or equal to about 97%.

A full width at half maximum (FWHM) of the first light (e.g., the green light or the red light) or a FWHM of the semiconductor nanoparticle may be greater than or equal to about 5 nm, greater than or equal to about 10 nm, greater than or equal to about 15 nm, greater than or equal to about 20 nm, greater than or equal to about 25 nm, or greater than or equal to about 30 nm. The full width at half maximum may be less than or equal to about 90 nm, less than or equal to about 85 nm, less than or equal to about 80 nm, less than or equal to about 75 nm, less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm.

A shape of the semiconductor nanoparticle thus prepared is not particularly limited, and may include, for example, spherical, polyhedral, pyramidal, multipod, cubic, nanotubes, nanowires, nanofibers, nanosheets, or a combination thereof, but is not limited thereto.

The semiconductor nanoparticle of an embodiment may include an organic ligand and/or an organic solvent on a surface of the semiconductor nanoparticle. The organic ligand and/or the organic solvent may be bound to a surface of the semiconductor nanoparticle of one or more embodiments.

In one or more embodiments, a composite may include a matrix; and the semiconductor nanoparticle described herein, wherein the semiconductor nanoparticle may be dispersed in the matrix. The composite may further contain a metal oxide fine particle. The composite may be configured to emit green light. In an embodiment, the composite may be in the form of a patterned film. The composite may further include a semiconductor nanoparticle configured to emit second light (e.g., red light) different from the green light. In an embodiment, the composite may have a sheet form. The sheet may further include a semiconductor nanoparticle (e.g., an additional semiconductor nanoparticle) configured to emit second light different from the green light.

The semiconductor nanoparticle described herein or the composite including the semiconductor nanoparticle may exhibit an increased level of blue light absorbance (e.g., an improved incident light absorbance) and/or improved optical properties (e.g., an increased luminescent efficiency and a narrower full width at half maximum), and may emit light of a desired wavelength (e.g., first light).

The composite may include the semiconductor nanoparticle of an embodiment or a population thereof (e.g., in a predetermined amount) and exhibit increased light absorbance. An incident light absorbance of the composite may be greater than or equal to about 70%, greater than or equal to about 73%, greater than or equal to about 75%, greater than or equal to about 77%, greater than or equal to about 80%, greater than or equal to about 83%, greater than or equal to about 85%, greater than or equal to about 87%, greater than or equal to about 90%, greater than or equal to about 93%, greater than or equal to about 94%, greater than or equal to about 95%, greater than or equal to about 96%, greater than or equal to about 97%, greater than or equal to about 98%, or greater than or equal to about 99%. The blue light absorbance of the composite may be about 70% to about 100%, about 80% to about 98%, about 95% to about 99%, about 96% to about 98%, or a combination thereof.

The incident light absorbance may be calculated according to the following equation:

$$\text{incident light absorbance} = [(B-B')/B] \times 100\%$$

wherein, in the equation,

B is an amount of incident light provided to the composite, and
B' is an amount of incident light passing through the composite.

A light conversion efficiency (CE) of the composite may be greater than or equal to about 7%, greater than or equal to about 8%, greater than or equal to about 9%, greater than or equal to about 10%, greater than or equal to about 11%, greater than or equal to about 12%, greater than or equal to about 12.5%, greater than or equal to about 12.9%, greater than or equal to about 13%, greater than or equal to about 14.5%, greater than or equal to about 15%, greater than or equal to about 15.5%, greater than or equal to about 16%, greater than or equal to about 16.5%, greater than or equal to about 16.7%, or greater than or equal to about 16.9%.

The light conversion efficiency is defined by the following equation:

$$\text{Light conversion efficiency (CE, \%)} = [A/(B-B')] \times 100$$

A: the amount of the first light from the composite;
B: the amount of incident light provided to the composite; and

B': the amount of incident light passing through the composite.

The present inventors have also found through their work that a luminescent nanoparticle including a semiconductor nanocrystal based on a Group 11-13-16 compound, even exhibiting a desired level of optical properties, may suffer a significant reduction of its optical properties for example when it is included in (or present in) a composite matrix, which may be required for an application of the nanoparticles in an actual working device. The semiconductor nanoparticle of an embodiment can provide a composite exhibiting improved optical properties by having the above-described composition and/or structural features, exhibiting high optical properties even in the form of a film. The semiconductor nanoparticle of an embodiment may exhibit significantly improved stability (e.g., thermal stability and atmospheric stability).

In an embodiment, the composite may be prepared from an ink composition. The ink composition may include a liquid vehicle; and a plurality of the semiconductor nanoparticles of one or more embodiments described herein. The semiconductor nanoparticle may be dispersed in the liquid vehicle.

The liquid vehicle may include a liquid monomer, an organic solvent, or a combination thereof. The ink composition may further include or may not substantially include a volatile organic solvent. The ink composition may further include a metal oxide nanoparticle(s) (e.g., dispersed in the liquid vehicle). The ink composition may further include a metal oxide fine particle(s) (e.g., metal oxide nanoparticle(s)) (e.g., dispersed in the liquid vehicle). The ink composition may further include a dispersant (for dispersing the semiconductor nanoparticles and/or the metal oxide nanoparticles). The dispersant may include a carboxylic acid group-containing organic compound (a monomer or a polymer). The liquid vehicle may not include an (e.g., volatile) organic solvent. The ink composition may be a solvent-free system.

The liquid monomer may include a (photo)polymerizable monomer including a carbon-carbon double bond. The composition may optionally further include a (thermal or photo) initiator. The polymerization of the composition may be initiated by light or heat.

Details of the semiconductor nanoparticle(s) in the composition (or composite) are as described herein. A content or amount of semiconductor nanoparticles in the composition (or composite) may be appropriately adjusted in consideration of a desired end use (e.g., a color filter, or the like). In one or more embodiments, an amount of the semiconductor nanoparticle in the composition (or composite) may be greater than or equal to about 1 wt%, for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt% based on the solid content of the composition or composite (hereinafter, the solid content may be a solid content of the composition or a solid content of the composite). The amount of the semiconductor nanoparticle may be less than or equal to about 70 wt%, for example, less than or equal to about 65 wt%, less than or equal to about 60 wt%, less than or equal to about 55 wt%, or less than or equal to about 50 wt%, based on the solid content of the composition or composite. A weight percentage of a given component with respect to a total solid content in a composition may represent an amount of the given component in the composite described herein.

In one or more embodiments, an ink composition may be a semiconductor nanoparticle-containing photoresist composition applicable in a photolithography manner. In one or more embodiments, an ink composition may be a semiconductor nanoparticle-containing composition capable of providing a pattern in a printing manner (e.g., a droplet discharging method such as an inkjet printing). The composition according to one or more embodiments may not include a conjugated (or conductive) polymer (except for a cardo binder to be described herein). The composition according to one or more embodiments may include a conjugated polymer. Herein, the conjugated polymer refers to a polymer (e.g., polyphenylenevinylene, or the like) having a conjugated double bond in the main chain.

In the composition according to one or more embodiments, the dispersant may ensure dispersibility of the semiconductor nanoparticles. In one or more embodiments, the dispersant may be a binder (or a binder polymer). The binder may include a carboxylic acid group (e.g., in the repeating unit). The binder may be an insulating polymer. The binder may be a carboxylic acid group-containing compound (a monomer or a polymer).

In the composition (or the composite), a content of the dispersant may be greater than or equal to about 0.5 wt%, for example, greater than or equal to about 1 wt%, greater than or equal to about 5 wt%, greater than or equal to about 10 wt%, greater than or equal to about 15 wt%, or greater than or equal to about 20 wt%, based on the total solid content of the composition (or composite). The content of the dispersant may be less than or equal to about 55 wt%, less than or equal to about 35 wt%, less than or equal to about 33 wt%, or less than or equal to about 30 wt%, based on the total solid content of the composition (or composite).

In the composition (or liquid vehicle), a liquid monomer or a polymerizable (e.g., photopolymerizable) monomer (hereinafter, referred to as a monomer) including the carbon-carbon double bond may include a (e.g., photopolymerizable) (meth)acryl-containing monomer. The monomer may be a precursor for an insulating polymer.

A content of the (photopolymerizable) monomer, based on a total weight of the composition, may be greater than or equal to about 0.5 wt%, for example, greater than or equal to about 1 wt%, greater than or equal to about 2 wt%, greater than or equal to about 3 wt%, greater than or equal to about 5 wt%, or greater than or equal to about 10 wt%. A content of the (photopolymerizable) monomer, based on the total weight of the composition, may be less than or equal to about 30 wt%, for example, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The (photo)initiator included in the composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the composition, the content of the initiator may be appropriately adjusted considering types and contents of the polymerizable monomers. In one or more embodiments, the content of the initiator may be greater than or equal to about 0.01 wt%, for example, greater than or equal to about 1 wt%, and less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight of the composition (or the total weight of the solid content), but is not limited thereto.

The composition (or composite) may further include a (poly- or mono-) thiol compound having at least one thiol group for example at a terminal end (or a moiety derived therefrom, such as a moiety produced by a reaction between a thiol and a carbon-carbon double bond, for example, a sulfide group), metal oxide particulate, or a combination thereof.

The metal oxide fine particles may include $TiO_2$, $SiO_2$, $BaTiO_3$, $Ba_2TiO_4$, ZnO, or a combination thereof. In the composition (or composite), a content of the metal oxide fine particle may be greater than or equal to about 1 wt%, greater than or equal to about 2 wt%, greater than or equal to about 3 wt%, greater than or equal to about 5 wt%, or greater than or equal to about 10 wt% to less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total solid content.

A diameter of the metal oxide fine particles is not particularly limited and may be appropriately selected. The diameter of the metal oxide fine particles may be greater than or equal to about 100 nm, for example greater than or equal to about 150 nm, or greater than or equal to about 200 nm and less than or equal to about 1000 nm, or less than or equal to about 800 nm.

The multithiol compound may be a dithiol compound, a trithiol compound, a tetrathiol compound, or a combination thereof. For example, the thiol compound may be ethylene glycol bis(3-mercaptopropionate), ethylene glycol dimercapto acetate, trimethylolpropane tris(3-mercaptopropionate), pentaerythritol tetrakis(3-mercaptopropionate), pentaerythritol tetrakis(2-mercaptoacetate), 1,6-hexanedithiol, 1,3-propanedithiol, 1,2-ethanedithiol, polyethylene glycol dithiol including 1 to 10 ethylene glycol repeating units, or a combination thereof.

In the composition (or composite), an amount of the thiol compound (or moieties derived therefrom) may be less than or equal to about 50 wt%, less than or equal to about 40 wt%, less than or equal to about 30 wt%, less than or equal to about 20 wt%, less than or equal to about 10 wt%, less than or equal to about 9 wt%, less than or equal to about 8 wt%, less than or equal to about 7 wt%, less than or equal to about 6 wt%, or less than or equal to about 5 wt%, based on the total solid content. The content of the thiol compound may be greater than or equal to about 0.1 wt%, for example, greater than or equal to about 0.5 wt%, greater than or equal to about 1 wt%, greater than or equal to about 5 wt%, greater than or equal to about 10 wt%, greater than or equal to about 15 wt%, greater than or equal to about 18 wt%, or greater than or equal to about 20 wt%, based on the total solid content.

The composition or the liquid vehicle may include an organic solvent. In some embodiments, the composition or the liquid vehicle may not include an organic solvent. If present, the type of organic solvent that may be used is not particularly limited. The type and amount of the organic solvent is appropriately determined in consideration of the types and amounts of the aforementioned main components (i.e., semiconductor nanoparticles, dispersants, polymerizable monomers, initiators, thiol compounds, or the like, if present) and other additives to be described herein. The composition may include a solvent in a residual amount except for a desired content of the (non-volatile) solid. In one or more embodiments, examples of the organic solvent may be an ethylene glycols such as ethylene glycol, diethylene glycol, polyethylene glycol, and the like; a glycol ether solvent such as ethylene glycol monomethylether, ethylene glycol monoethyl ether, diethylene glycol monomethyl ether, ethylene glycol diethyl ether, diethylene glycol dimethyl ether, or the like; a glycol ether acetate solvent such as ethylene glycol monomethyl ether acetate, ethylene glycol monoethyl ether acetate, diethylene glycol monoethyl ether acetate, diethylene glycol monobutyl ether acetate, or the like; a propylene glycol solvent such as propylene glycol, or the like; a propylene glycol ether solvent such as propylene glycol monomethyl ether, propylene glycol monoethyl ether, propylene glycol monopropyl ether, propylene glycol monobutyl ether, propylene glycol dimethyl ether, dipropylene glycol dimethyl ether, propylene glycol diethyl ether, dipropylene glycol diethyl ether, or the like; a propylene glycol ether acetate solvent such as propylene glycol monomethyl ether acetate, dipropylene glycol monoethyl ether acetate, or the like; an amide solvent such as N-methylpyrrolidone, dimethyl formamide, dimethyl acetamide, or the like; a ketone solvent such as methylethylketone (MEK), methylisobutylketone (MIBK), cyclohexanone, or the like; a petroleum solvent such as toluene, xylene, solvent naphtha, or the like; an ester solvent such as ethyl acetate, butyl acetate, ethyl lactate, ethyl 3-ethoxy propionate, or the like; an ether solvent such as diethyl ether, dipropyl ether, dibutyl ether, or the like; chloroform, a C1 to C40 aliphatic hydrocarbon solvent (e.g., alkane, alkene, or alkyne), a halogen (e.g., chloro) substituted C1 to C40 aliphatic hydrocarbon solvent (e.g., dichloroethane, trichloromethane, or the like), a C6 to C40 aromatic hydrocarbon solvent (e.g., toluene, xylene, or the like), a halogen (e.g., chloro) substituted C6 to C40 aromatic hydrocarbon solvent; or a combination thereof.

In addition to the aforementioned components, the composition (or composite) of one or more embodiments may further include an additive such as a light diffusing agent, a leveling agent, a coupling agent, or a combination thereof. Components (binder, monomer, solvent, additives, thiol compound, cardo binder, or the like) included in the composition of one or more embodiments may be appropriately selected, and for specific details thereof, for example, US-2017-0052444-A1 may be referred.

In the preparation of the composition according to an embodiment, each of the above-described components may be manufactured sequentially or simultaneously mixed, and the order thereof is not particularly limited.

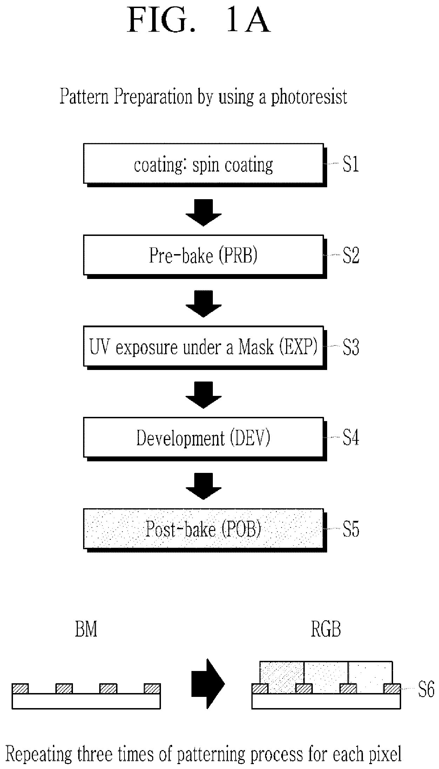

The composition may provide a color conversion layer (or a patterned film of the composite) by (e.g., radical) polymerization. The color conversion layer (or the patterned film of the composite) may be produced using a photoresist composition. Referring to FIG. 1A, this method may include forming a film of the aforementioned composition on a substrate (S1); prebaking the film according to selection (S2); exposing a selected region of the film to light (e.g., having a wavelength of less than or equal to about 400 nm) (EXP) (S3); and developing the exposed film with an alkali developing solution (DEV) to obtain a pattern of a composite (S4).

Referring to FIG. 1A, the aforementioned composition may be applied to a predetermined thickness on a substrate using an appropriate method such as spin coating or slit coating to form a film. The formed film may be optionally subjected to a pre-baking (PRB) step. The pre-baking may be performed by selecting an appropriate condition from known conditions of a temperature, time, an atmosphere, or the like.

The formed (or optionally prebaked) film is exposed to light having a predetermined wavelength under a mask having a predetermined pattern. A wavelength and intensity of the light may be selected considering types and contents of the photoinitiator, types and contents of the quantum dots (i.e., the semiconductor nanoparticles), or the like.

The exposed film may then be treated with an alkali developing solution (e.g., dipping or spraying) to dissolve an unexposed region and obtain a desired pattern. The obtained pattern may be, optionally, post-exposure baked (POB) to improve crack resistance and solvent resistance of the pattern, for example, at a temperature of about 150°C to about 230°C for a predetermined time (e.g., greater than or equal to about 10 minutes, or greater than or equal to about 20 minutes) (S5).

When the color conversion layer or the patterned film of the composite has a plurality of repeating sections (that is, color conversion regions), each repeating section may be formed by preparing a plurality of compositions including quantum dots (e.g., red light emitting quantum dots, green light emitting quantum dots, or optionally, blue light emitting quantum dots) having desired luminous properties (photoluminescence peak wavelength or the like) and repeating the aforementioned pattern-forming process as many times as necessary (e.g., 2 times or more or 3 times or more) for each composition, resultantly obtaining a composite having a desired pattern (S6). For example, the composite may have a pattern of at least two repeating color sections (e.g., RGB color sections). This composite pattern may be used as a photoluminescence type color filter in a display device.

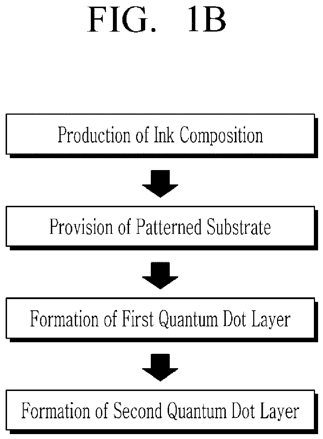

The color conversion layer or patterned film of the composite may be produced using an ink composition configured to form a pattern in an inkjet manner. Referring to FIG. 1B, such a method may include preparing an ink composition according to one or more embodiments, providing a substrate (e.g., with pixel areas patterned by electrodes and optionally banks or trench-type partition walls, or the like), and depositing an ink composition on the substrate (or the pixel area) to form, for example, a first composite layer (or first region). The method may include depositing an ink composition on the substrate (or the pixel area) to form, for example, a second composite layer (or second region). The forming of the first composite layer and forming of the second composite layer may be simultaneously or sequentially carried out.

The depositing of the ink composition may be performed using an appropriate liquid crystal discharger, for example an inkjet or nozzle printing system (having an ink storage and at least one print head). The deposited ink composition may provide a (first or second) composite layer (e.g., first quantum dot layer or second quantum dot layer) through the solvent removal and polymerization by the heating. The method may provide a highly precise composite film or patterned film for a short time by the simple method.

In the composite (e.g., first composite) of one or more embodiments, the (polymer) matrix may include the components described herein with respect to the composition. In the composite, an amount of the (polymer) matrix, based on a total weight of the composite, may be greater than or equal to about 10 wt%, greater than or equal to about 20 wt%, greater than or equal to about 30 wt%, greater than or equal to about 40 wt%, greater than or equal to about 50 wt%, or greater than or equal to about 60 wt%. The amount of the (polymer) matrix may be, based on a total weight of the composite, less than or equal to about 95 wt%, less than or equal to about 90 wt%, less than or equal to about 80 wt%, less than or equal to about 70 wt%, less than or equal to about 60 wt%, or less than or equal to about 50 wt%.

The (polymer) matrix may include at least one of a dispersant (e.g., a carboxylic acid group-containing binder polymer), a polymerization product (e.g., an insulating polymer) of a polymerizable monomer including (at least one, for example, at least two, at least three, at least four, or at least five) carbon-carbon double bonds, and a polymerization product of the polymerizable monomer and a multithiol compound having at least two thiol groups at a terminal end. The (polymer) matrix may include a linear polymer, a crosslinked polymer, or a combination thereof. The (polymer) matrix may not include a conjugated polymer (excluding cardo resin). The (polymer) matrix may include a conjugated polymer.

The crosslinked polymer may include a thiol-ene resin, a crosslinked poly(meth)acrylate, a crosslinked polyurethane, a crosslinked epoxy resin, a crosslinked vinyl polymer, a crosslinked silicone resin, or a combination thereof. In one or more embodiments, the crosslinked polymer may be a polymerization product of the aforementioned polymerizable monomers and optionally a multithiol compound.

The linear polymer may include a repeating unit derived from a carbon-carbon unsaturated bond (e.g., a carbon-carbon double bond). The repeating unit may include a carboxylic acid group. The linear polymer may include an ethylene repeating unit.

The carboxylic acid group-containing repeating unit may include a unit derived from a monomer including a carboxylic acid group and a carbon-carbon double bond, a unit derived from a monomer having a dianhydride moiety, or a combination thereof.

The (polymer) matrix may include a carboxylic acid group-containing compound (e.g., a binder, a binder polymer, or a dispersant) (e.g., for dispersion of semiconductor nanoparticles or a binder).

The composite (or film or pattern thereof) may have, for example, a thickness of less than or equal to about 25 $\mu$m, less than or equal to about 20 $\mu$m, less than or equal to about 15 $\mu$m, less than or equal to about 10 $\mu$m, less than or equal to about 8 $\mu$m, or less than or equal to about 7 $\mu$m and greater than or equal to about 2 $\mu$m, for example, greater than or equal to about 3 $\mu$m, greater than or equal to about 3.5 $\mu$m, greater than or equal to about 4 $\mu$m, greater than or equal to about 5 $\mu$m, greater than or equal to about 6 $\mu$m, greater than or equal to about 7 $\mu$m, greater than or equal to about 8 $\mu$m, greater than or equal to about 9 $\mu$m, or greater than or equal to about 10 $\mu$m.

The aforementioned semiconductor nanoparticle(s), a composite (pattern) including the aforementioned semiconductor nanoparticle(s), or a color conversion panel including the same may be included in an electronic device. Such an electronic device may include a display device, a light emitting diode (LED), an organic light emitting diode (OLED), a quantum dot LED, a sensor, a solar cell, an imaging sensor, a photodetector, or a liquid crystal display device, but embodiments are not limited thereto. The aforementioned quantum dot may be included in an electronic apparatus. Such an electronic apparatus may include a portable terminal device, a monitor, a notebook PC, a television, an electric sign board, a camera, a car, or the like, but embodiments are not limited thereto. The electronic apparatus may be a portable terminal device, a monitor, a note PC, or a television including a display device (or a light emitting device) including quantum dots. The electronic apparatus may be a camera or a mobile terminal device including an image sensor including quantum dots. The electronic apparatus may be a camera or a vehicle including a photodetector including quantum dots.

An embodiment provides a color conversion layer (e.g., a color conversion structure or a color conversion panel) including a color conversion region including the semiconductor nanoparticle described herein. The color conversion panel includes a color conversion layer including a color conversion region and optionally a partition wall defining each region of the color conversion layer, the color conversion region includes a first region corresponding to a first pixel, and the first region includes the semiconductor nanoparticles or the composite. In the color conversion panel of an embodiment, the composite may be in the form of a patterned film. In another embodiment, the composite may have a sheet form.

The color conversion panel of an embodiment may include a color conversion layer including a color conversion region and optionally a partition wall defining each region of the color conversion layer. The color conversion region may include a first region corresponding to a first pixel. The first region includes a first composite, and the first composite includes a matrix and semiconductor nanoparticles dispersed in the matrix and is configured to emit first light. An embodiment provides the semiconductor nanoparticle or a population thereof.

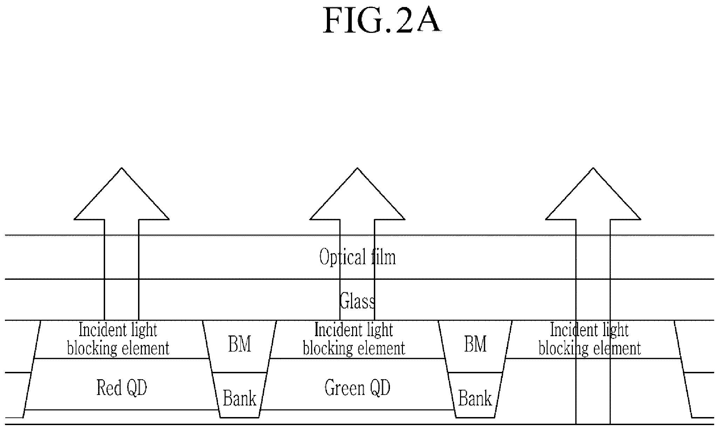

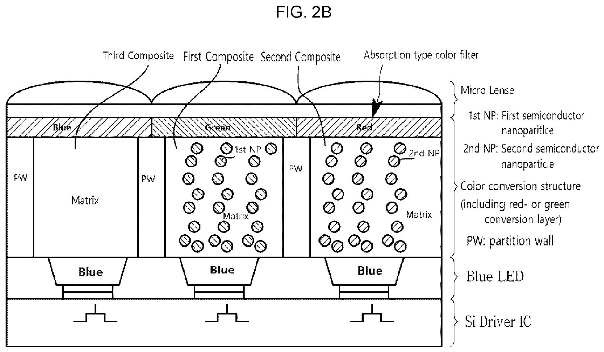

The color conversion layer (e.g., a color conversion structure) may include the composite or a patterned film thereof according to one or more embodiments. FIG. 2A is a schematic cross-sectional view of a color conversion panel according to one or more embodiments. Referring to FIG. 2A, the color conversion panel may optionally further include a partition wall (e.g., a black matrix (BM), a bank, or a combination thereof) that defines each region of the color conversion layer (e.g., a color conversion structure). FIG. 2B illustrates an electronic device (a display device) including a color conversion panel and a light source according to another embodiment. In the electronic device of one or more embodiments, a color conversion panel including a color conversion layer or a color conversion structure is disposed on an LED on a chip (e.g., a micro LED on a chip). Referring to FIG. 2B, a circuit (Si driver IC) configured to drive the light source may be disposed under a light source (e.g., blue LED) configured to emit incident light (e.g., a blue light). The color conversion layer may include a first composite including a first semiconductor nanoparticle emitting a first light (e.g., a green light), and a second composite including a second semiconductor nanoparticle emitting a second light (e.g., a red light), or a third composite that emits or passes a third light (e.g., incident light or a blue light). A partition wall PW (e.g., including an inorganic material such as silicon or silicon oxide, or based on an organic material) may be disposed between respective composites. The partition wall may include a trench hole, a via hole, or a combination thereof. A first optical element (e.g., an absorption type color filter) may be disposed on a light extraction surface of a color conversion layer. An additional optical element such as a micro lens may be further disposed on the first optical element.

The color conversion region includes a first region configured to emit the aforementioned first light (or green light) (e.g., by irradiation with an incident light). In one or more embodiments, the first region may correspond to a green pixel. The first region includes a first composite (e.g., a luminescence type composite). The first light may have a peak emission wavelength within a wavelength range to be described later. The first light will be described in more detail for the semiconductor nanoparticles described herein. The peak emission wavelength of the green light may be greater than or equal to about 500 nm, greater than or equal to about 501 nm, greater than or equal to about 504 nm, greater than or equal to about 505 nm, or greater than or equal to about 520 nm. The peak emission wavelength of the green light may be less than or equal to about 580 nm, less than or equal to about 560 nm, less than or equal to about 550 nm, less than or equal to about 530 nm, less than or equal to about 525 nm, less than or equal to about 520 nm, less than or equal to about 515 nm, or less than or equal to about 510 nm.

The color conversion region may further include a (e.g., one or more) second region that is configured to emit a second light (e.g., a red light) different from the first light (e.g., by irradiation with excitation light). The second region may include a second composite. The second composite in the second region may include a semiconductor nanoparticle (e.g., a quantum dot) being configured to emit a light of a different wavelength (e.g., a different color) from the first composite disposed in the first region.

The second light may be a red light having a peak emission wavelength of about 600 nm to about 650 nm (e.g., about 620 nm to about 650 nm). The color conversion panel may further include (one or more) third regions that emit or pass a third light (e.g., a blue light) different from the first light and the second light. An incident light may include the third light (e.g., a blue light and optionally a green light). The third light may include a blue light having a peak emission wavelength of greater than or equal to about 380 nm (e.g., greater than or equal to about 440 nm, greater than or equal to about 445 nm, greater than or equal to about 450 nm, or greater than or equal to about 455 nm) and less than or equal to about 480 nm (e.g., less than or equal to about 475 nm, less than or equal to about 470 nm, less than or equal to about 465 nm, or less than or equal to about 460 nm).

In one or more embodiments, the color conversion panel or the color conversion layer may include a plurality of first regions, and the composite may constitute a predetermined pattern to be respectively disposed in the first regions of the color conversion panel. The composite (or a pattern thereof) may be prepared from the (ink) composition by any method, for example, in a photolithography manner or in an inkjet printing manner. Accordingly, one or more embodiments relates to a composition including a semiconductor nanoparticle, which was described herein in further detail.

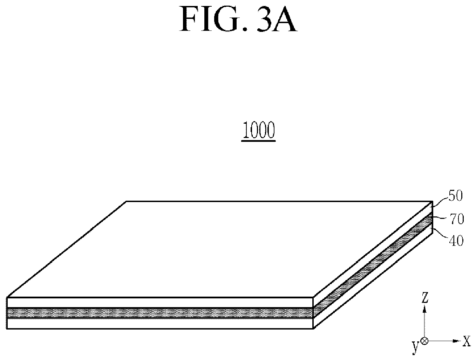

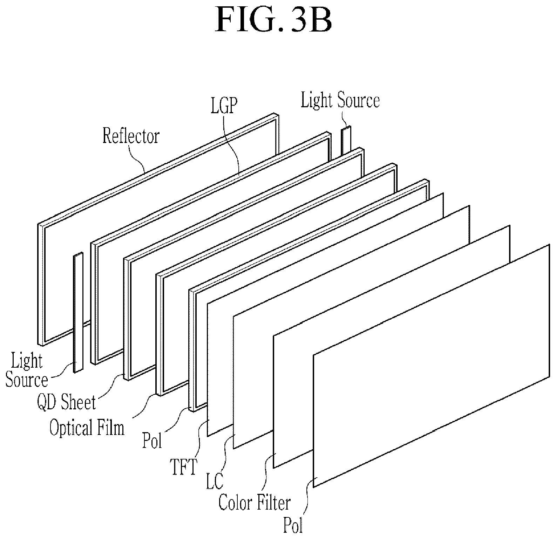

In one or more embodiments, the electronic device or the display device (e.g., display panel) may further include a color conversion layer (or a color conversion panel) and optionally, a light source. See, FIGs. 3A and 3B. The light source may provide incident light to the color conversion layer or the color conversion panel. In one or more embodiments, the display panel 1000 includes a light emitting panel 40 (or a light source), the aforementioned color conversion panel 50, and a light transmitting layer 70 located between the aforementioned light emitting panel 40 and the aforementioned color conversion panel 50. The color conversion panel includes a substrate, and the color conversion layer may be disposed on the substrate.

When present, the light source or the light emitting panel may provide an incident light to the color conversion layer or the color conversion panel. The incident light may have a peak emission wavelength of greater than or equal to about 440 nm, for example, greater than or equal to about 450 nm and less than or equal to about 580 nm, for example, less than or equal to about 480 nm, less than or equal to about 470 nm, or less than or equal to about 460 nm.

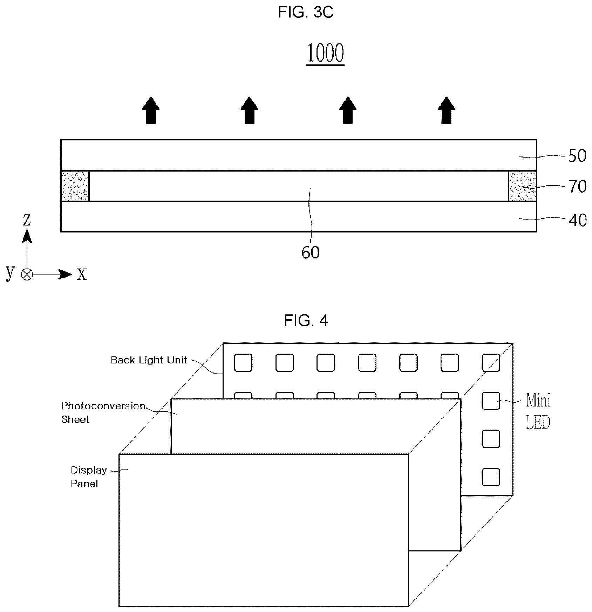

In one or more embodiments, the electronic device (e.g., a photoluminescent device) may further include a sheet of the nanoparticle composite. Referring to FIG. 3B, the device may include a backlight (including a light source) unit and a liquid crystal panel LC, wherein the backlight unit may include a quantum dot polymer composite sheet (QD sheet). Specifically, the backlight unit may have a structure that a reflector, a light guide plate (LGP), a light source (a blue LED or the like), the quantum dot polymer composite sheet (QD sheet), and an optical film (a prism, a double brightness enhance film (DBEF, or the like) may be stacked. The liquid crystal panel may be disposed on the backlight unit and have a structure where a thin film transistor (TFT), liquid crystals (LC), and a color filter (color filter) are included between two polarizers (Pol). The quantum dot polymer composite sheet (QD sheet) may include semiconductor nanoparticles (e.g., quantum dots) emitting a red light and a green light after absorbing light from the light source. A blue light provided from the light source may be combined with the red light and the green light emitted from the respective semiconductor nanoparticles, while passing the quantum dot polymer composite sheet, and converted into a white light. The white light may be separated into a blue light, a green light, and a red light by a color filter in the liquid crystal panel, and then emitted to the outside for each pixel. Referring to Fig. 4, the backlight unit (BLU) may be a direct type of a BLU without a light guide plate, and may include a plurality of LEDs (e.g., mini LEDs).

The color conversion panel may include a substrate, and the color conversion layer may be disposed on the substrate. The color conversion layer or the color conversion panel may include a patterned film of the composite. The patterned film may include a repeating section that is configured to emit light of a desired wavelength. The repeating section may include a second region. The second region may be a red light-emitting section. The repeating section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light, and, optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In one or more embodiments, the light source may include an organic light emitting diode to emit a blue light and an organic light emitting diode to emit a green light, a green light removing filter may be further disposed in a third region through which a blue light is transmitted.

The light emitting panel or the light source may include a plurality of light emitting units respectively corresponding to the first region and the second region, and the light emitting units may include a first electrode and a second electrode facing each other, and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to the drawings.

Referring to FIGS. 3A and 3C, the display panel 1000 according to one or more embodiments includes a light emitting panel 40 and a color conversion panel 50. The display panel or the electronic device may further include a light transmitting layer 60 disposed between the light emitting panel 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each have a surface opposite the other, i.e., the two respective panels face each other, with the light transmitting layer (or the light transmitting panel) 60 disposed between the two panels. The color conversion panel 50 is disposed in a direction such that for example, light emitting from the light emitting panel 40 irradiates the light transmitting layer 60. The binding material 70 is disposed along edges of the light emitting panel 40 and the color conversion panel 50, and may be, for example, a sealing material.

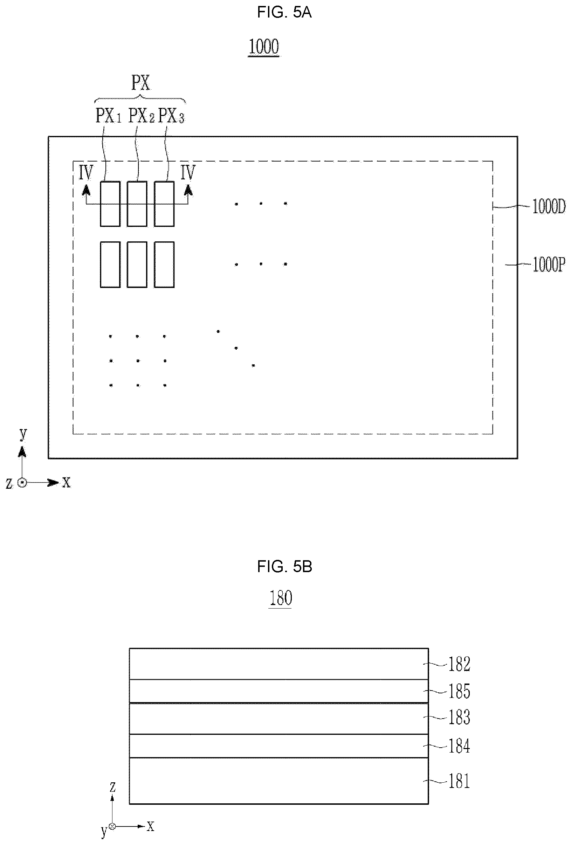

FIG. 5A is a plan view of one or more embodiments of a pixel arrangement of a display panel. Referring to FIG. 5A, the display panel 1000 includes a display area 1000D displaying an image and a non-display area 1000P positioned in a peripheral area of the display area 1000D and disposed with a binding material.

The display area 1000D includes a plurality of pixels PX arranged along a row (e.g., an x direction), a column (e.g., a y direction), and each representative pixel PX may include a plurality of sub-pixels $PX_1$, $PX_2$, and $PX_3$ expressing, e.g., displaying, different colors from each other. One or more embodiments are exemplified with a structure in which three sub-pixels $PX_1$, $PX_2$, and $PX_3$ are configured to provide a pixel. One or more embodiments may further include an additional sub-pixel such as a white sub-pixel and may further include, e.g., at least one, sub-pixel expressing, e.g., displaying the same colors. The plurality of pixels PX may be aligned, for example, in a Bayer matrix, a matrix sold under the trade designation PenTile, a diamond matrix, or the like, or a combination thereof.

The sub-pixels $PX_1$, $PX_2$, and $PX_3$ may express, e.g., display, three primary colors or a color of a combination of three primary colors, for example, may express, e.g., display, a color of red, green, blue, or a combination thereof. For example, the first sub-pixel $PX_1$ may express, e.g., display, a red color, and the second sub-pixel $PX_2$ may express, e.g., display, a green color, and the third sub-pixel $PX_3$ may express, e.g., display, a blue color.

In the drawing, all sub-pixels are exemplified to have the same size, but these are not limited thereto, and at least one of the sub-pixels may be larger or smaller than other sub-pixels. In the drawing, all sub-pixels are exemplified to have the same shape, but it is not limited thereto and at least one of the sub-pixels may have different shape from the other sub-pixels.

In the display panel or electronic device according to one or more embodiments, the light emitting panel may include a substrate and a TFT (e.g., an oxide-containing TFT, or the like) disposed on the substrate. A light emitting device (e.g., having a tandem structure, or the like) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof.

FIGS. 5B to 5E are cross-sectional views showing examples of light emitting devices, respectively. In an embodiment, "a mini LED" may have a size of greater than or equal to about 100 micrometers, greater than or equal to about 150 micrometers, greater than or equal to about 200 micrometers and less than or equal to about 1 millimeter, less than or equal to about 0.5 millimeters, less than or equal to about 0.15 millimeters, or less than or equal to about 0.12 millimeters, but is not limited thereto. In an embodiment, "a micro LED" may have a size of less than or equal to about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers, but is not limited thereto.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and located between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or multiple layers of a metal thin film including conductive metal oxides such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a peak emission wavelength in a wavelength region of greater than or equal to about 400 nm and less than about 500 nm and within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a peak emission wavelength in a wavelength region of greater than or equal to about 500 nm and less than about 590 nm and within the range, in a wavelength region of about 510 nm to about 580 nm, about 515 nm to about 570 nm, about 520 nm to about 560 nm, about 525 nm to about 555 nm, about 530 nm to about 550 nm, or about 535 nm to about 545 nm.

For example, the light emitting layers 183 or the light emitting body included therein may include a phosphorescent material, a fluorescent material, or a combination thereof. For example, the light emitting body may include an organic light emitting body, wherein the organic light emitting body may be a low molecular compound, a polymer compound, or a combination thereof. Specific types of the phosphorescent material and the fluorescent material are not particularly limited but may be appropriately selected from known materials. For example, the light emitting body may include an inorganic light emitting body, and the inorganic light emitting body may be an inorganic semiconductor, a quantum dot, a perovskite, or a combination thereof. The inorganic semiconductor may include metal nitride, metal oxide, or a combination thereof. The metal nitride, the metal oxide, or the combination thereof may include a Group III metal such as aluminum, gallium, indium, thallium, or the like, a Group IV metal such as silicon, germanium, tin, or a combination thereof. In one or more embodiments, the light emitting body may include an inorganic light emitting body, and the light emitting device 180 may be a quantum dot light emitting diode, a perovskite light emitting diode, or a micro light emitting diode ($\mu$LED). Materials usable as the inorganic light emitting body may be selected appropriately.

In one or more embodiments, the light emitting device 180 may further include an auxiliary layer 184 and 185. The auxiliary layer 184 and 185 may be disposed between a first electrode 181 and a light emitting layer 183, and/or between a second electrode 182 and a light emitting layer 183, respectively. The auxiliary layer 184 and 185 may be a charge auxiliary layer for controlling injection and/or mobility of charges. The auxiliary layers 184 and 185 may include at least one layer or two layers, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layer may be formed of a material appropriately selected from materials known for an organic electroluminescent device, or the like.

The light emitting devices 180 disposed in each of the subpixels $PX_1$, $PX_2$, and $PX_3$ may be the same or different from each other. The light emitting devices 180 in each of the subpixels $PX_1$, $PX_2$, and $PX_3$ may emit a light having the same or different emission spectra. The light emitting devices 180 in each of the subpixels $PX_1$, $PX_2$, and $PX_3$ may emit, for example, light having a blue emission spectrum, light having a green emission spectrum, or a combination thereof. The light emitting devices 180 in each of the subpixels $PX_1$, $PX_2$, and $PX_3$ may be separated by a pixel defining layer (not shown).

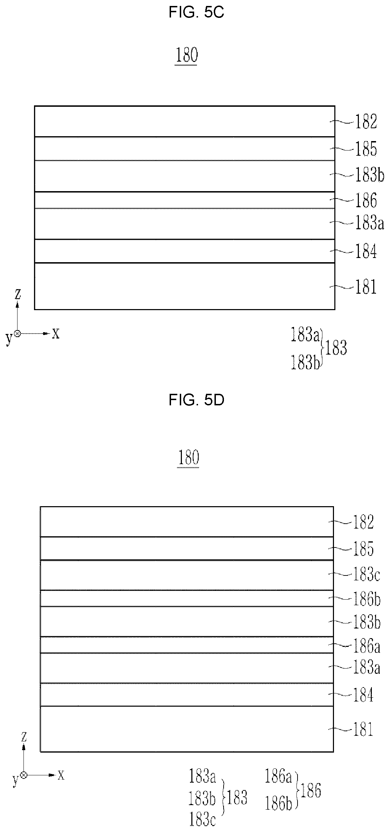

Referring to FIG. 5C, the light emitting device 180 may be a light emitting device having a tandem structure, and includes a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b, and optionally auxiliary layers 184 and 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In one or more embodiments, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and 185 located between the first electrode 181 and the first light emitting layer 183a, and/or between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In one or more embodiments, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a and 186b may include one layer or two or more layers, respectively.

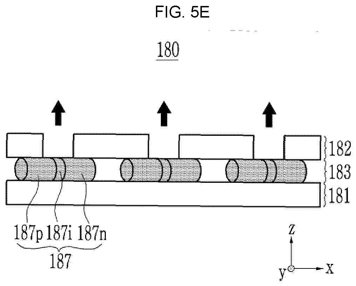

Referring to FIG. 5E, in one or more embodiments, the light emitting device 180 includes a light emitting layer 183, a first electrode 181, a second electrode 182, and a plurality of nanostructures 187 arranged in the light emitting layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), fluorine-doped tin oxide (FTO), or the like; silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels $PX_1$, $PX_2$, and $PX_3$ may include a plurality of nanostructures 187. In one or more embodiments, the plurality of nanostructures 187 may be arranged in one direction, but embodiments are not limited thereto. The nanostructures 187 may be a compound-containing semiconductor that is configured to emit light of a predetermined wavelength for example with an application of an electric current, and may be, for example, a linear nanostructure such as a nanorod or a nanoneedle. A diameter or a long diameter of the nanostructures 187 may be, for example, several nanometers to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5, greater than or equal to about 5.0, greater than about 1 to less than or equal to about 20, about 1.5 to about 20, about 2.0 to about 20, about 3.0 to about 20, about 4.0 to about 20, about 4.5 to about 20, or about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit light having the same or different emission spectra. In one or more embodiments, the nanostructure may emit light of a blue emission spectrum, for example, light of a blue emission spectrum having a peak emission wavelength in a wavelength region of greater than or equal to about 400 nm to less than 500 nm, about 410 nm to about 490 nm, or about 420 nm to about 480 nm.

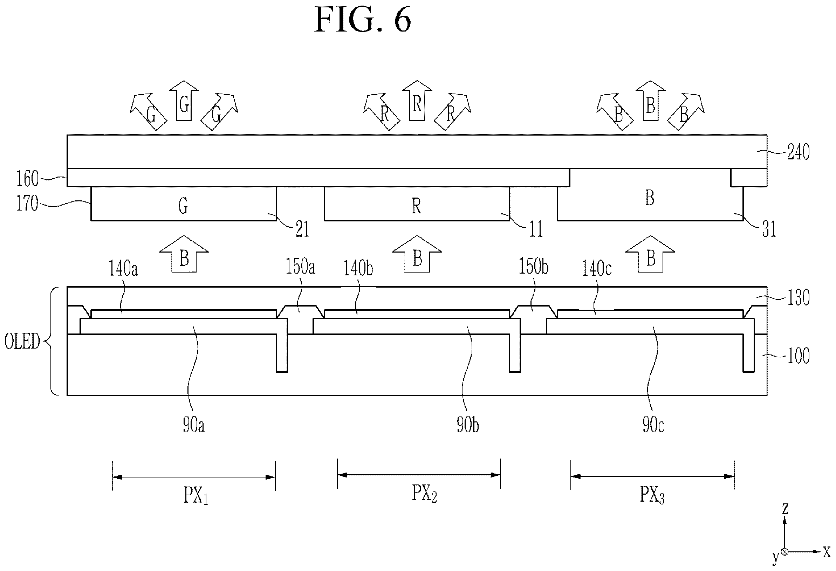

FIG. 6 is a schematic cross-sectional view of a device (or a display panel) according to one or more embodiments. Referring to FIG. 6, the light source (or the light emitting panel) may include an organic light emitting diode that emits a blue light (B) (and optionally a green light (G)). The organic light emitting diode (OLED) may include at least two pixel electrodes 90a, 90b, 90c formed on the substrate 100, pixel defining layers 150a, 150b formed between the adjacent pixel electrodes 90a, 90b, 90c, organic light emitting layers 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions described herein. In one or more embodiments, the color conversion panel and the light emitting panel may be separated as shown in FIG. 6. In one or more embodiments, the color conversion panel may be stacked directly on the light emitting panel.

A laminated structure including the luminescent nanostructure composite pattern 170 (e.g., a first region 11 or R including red light emitting luminescent nanostructures, a second region 21 or G including green light emitting luminescent nanostructures, and a third region 31 or B including or not including a luminescent nanostructure, e.g., a blue light emitting luminescent nanostructure) and substrate 240 may be disposed on the light source. The blue light emitted from the light source enters the first region and second region and may emit a red light and a green light, respectively. The blue light emitted from the light source may pass through the third region. An element (first optical filter 160 or excitation light blocking layer) configured to block the excitation light may be disposed between the luminescent nanostructure composite layers R and G and the substrate, if desired. In one or more embodiments, the excitation light includes a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the luminescent nanostructure composite pattern on the LED or OLED.

In the color conversion panel or a display device, a substrate may be a substrate including an insulation material. The substrate may include glass; a polymer such as a polyester of poly(ethylene terephthalate) (PET), polyethylene naphthalate) (PEN), or the like, a polycarbonate, or a polyacrylate; a polysiloxane (e.g. PDMS, or the like); an inorganic material such as $Al_2O_3$, ZnO, or the like; or a combination thereof, but embodiments are not limited thereto. A thickness of the substrate may be appropriately selected taking into consideration a substrate material but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a semiconductor layer, a protective layer, or the like. The detailed structure of the wire layer may vary depending on one or more embodiments. The gate line and the sustain voltage line may be electrically separated from each other, and the data line may be insulated and crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described herein.

The pixel electrode may function as an electrode (e.g., anode) of the display device. The pixel electrode may be formed of a transparent conductive material such as indium tin oxide (ITO) or indium zinc oxide (IZO). The pixel electrode may be formed of a material having a light blocking property such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of the pixel electrode where it is not covered by the pixel define layer may provide an opening. An organic light emitting layer that will be described herein may be formed in the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to one or more embodiments, the organic light emitting layer may be defined as a first pixel area, a second pixel area, and a third pixel area, and each pixel area may be spaced apart from each other leaving a predetermined interval by the pixel define layer.

In one or more embodiments, the organic light emitting layer may emit a third light belonging to a visible light region or belonging to an ultraviolet (UV) region. Each of the first to the third pixel areas of the organic light emitting layer may emit a third light. In one or more embodiments, the third light may be a light having a higher energy in a visible light region, and for example, may be a blue light (and optionally a green light). In one or more embodiments, all pixel areas of the organic light emitting layer are designed to emit the same light, and each pixel area of the organic light emitting layer may be formed of materials that are the same or similar or may show the same or similar properties. Thus, a process of forming the organic light emitting layer may be simplified, and the display device may be easily applied for, e.g., made by, a large scale/large area process. However, the organic light emitting layer according to one or more embodiments is not necessarily limited thereto, but the organic light emitting layer may be designed to emit at least two different lights, e.g., at least two different colored lights.

The organic light emitting layer includes an organic light emitting unit layer in each pixel area, and each organic light emitting unit layer may further include an auxiliary layer (e.g., a hole injection layer, a hole transport layer, an electron transport layer, or the like) besides the light emitting layer.

The common electrode may function as a cathode of the display device. The common electrode may be formed of a transparent conductive material such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In one or more embodiments, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED, and, if desired, a light guide plate.

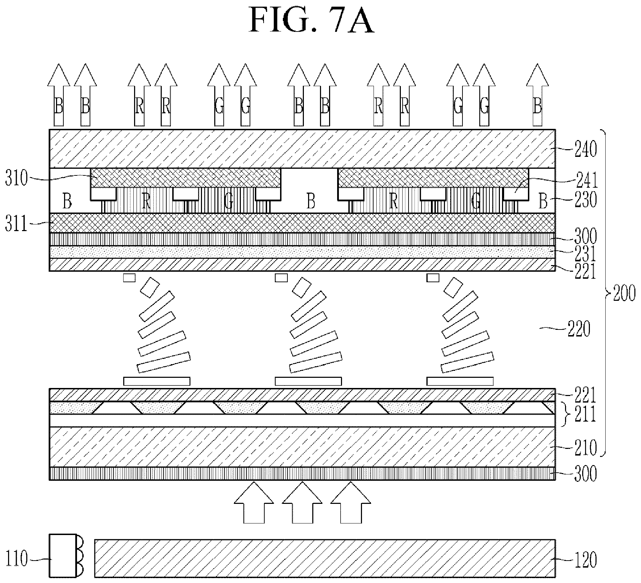

In one or more embodiments, the display device (e.g., a liquid crystal display device) are illustrated with a reference to a drawing. FIG. 7A is a schematic cross-sectional view showing a liquid crystal display device according to one or more embodiments. Referring to FIG. 7A, the display device of one or more embodiments includes a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material substrate. The substrate may be as described herein. A wire plate 211 may be provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any polarizer that can be used in a liquid crystal display device. The polarizing plate may be triacetyl cellulose (TAC) having a thickness of less than or equal to about 200 μm, but is not limited thereto. In another embodiment, the upper optical element may be a coating that controls a refractive index without a polarization function.

The backlight unit includes a light source 110. The light source may emit a blue light or a white light. The light source may include, but is not limited to, a blue LED, a white LED, a white OLED, or a combination thereof.

The backlight unit may further include a light guide plate 120. In one or more embodiments, the backlight unit may be of an edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, and the like, but the present disclosure is not limited thereto. The backlight unit may not include a light guide plate. In one or more embodiments, the backlight unit may be direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and has openings and hides a gate line, a data line, and a thin film transistor of the wire plate on the lower substrate. For example, the black matrix 241 may have a grid shape. The photoluminescent layer 230 is provided in the opening of the black matrix 241 and has a nanoparticle-polymer composite pattern including a first region (R) configured to emit a first light (e.g., a red light), a second region (G) configured to emit a second light (e.g., a green light), and a third region (B) configured to emit/transmit a third light, for example a blue light. If desired, the photoluminescent layer may further include at least one fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas formed on the lower substrate. A transparent common electrode 231 may be provided on the photoluminescent layer 230.

The third region (B) configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to one or more embodiments may further include an excitation light blocking layer or a first optical filter layer (hereinafter, referred to as a first optical filter layer). The first optical filter layer may be disposed between the bottom surface of the first region (R) and the second region (G) and the substrate (e.g., the upper substrate 240) or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 2A, 2B, 6 and/or 7A, but is not limited thereto. Two or more first optical filter layers may be spaced apart from each other at positions overlapped with the first and second regions, and optionally, the third region. When the light source includes a green light emitting device, a green light blocking layer may be disposed in the third region.

The first optical filter layer may block light, for example, in a predetermined wavelength region in the visible light region and may transmit light in the other wavelength regions, and for example, it may block a blue light (or a green light) and may transmit light except the blue light (or the green light). The first optical filter layer may transmit, for example, a green light, a red light, and/or a yellow light that is a mixed light thereof. The first optical filter layer may transmit a blue light and block a green light, and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) the blue light and the red light and selectively transmits light of a predetermined range (e.g., greater than or equal to about 500 nm, greater than or equal to about 510 nm, or greater than or equal to about 515 nm to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In one or more embodiments, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizer), transmits at least a portion of the third light (excitation light), and reflects at least a portion of the first light and/or the second light. The first light may be a red light, the second light may be a green light, and the third light may be a blue light. The second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second regions and to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength which is to be blocked. The second optical filter layer or the first optical filter layer may include a single layer having a low refractive index, and may be, for example, a transparent thin film having a refractive index of less than or equal to about 1.4, less than or equal to about 1.3, or less than or equal to about 1.2. The second optical filter layer or the first optical filter layer having a low refractive index may include, for example, a porous silicon oxide, a porous organic material, a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

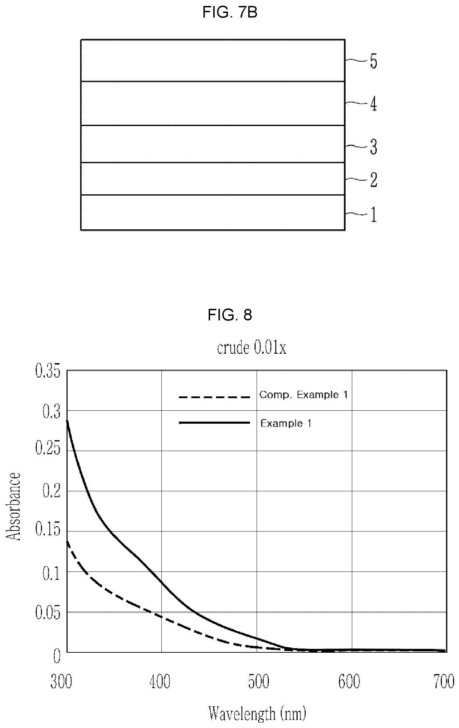

In one or more embodiments, the electronic device may include a light emitting device (e.g., an electroluminescent device) including the semiconductor nanoparticles described above. FIG. 7B is a schematic cross-sectional view of a light emitting device (electroluminescent device) according to one or more embodiments. Referring to FIG. 7B, the light emitting device includes an anode 1 and a cathode 5 facing each other; a quantum dot light emitting layer 3 disposed between the anode and the cathode and including a plurality of quantum dots; and a hole auxiliary layer 2 located between the anode and the quantum dot light emitting layer. The hole auxiliary layer may include a hole injecting layer (HIL), a hole transporting layer (HTL), an electron blocking layer (EBL), or a combination thereof. The hole auxiliary layer may include any organic/inorganic material having hole characteristics. The light emitting device may further include an electron auxiliary layer 4 located between the cathode and the quantum dot light emitting layer. The electron auxiliary layer may include an electron injecting layer (EIL), an electron transporting layer (ETL), a hole blocking layer (HBL), or a combination thereof. The electron auxiliary layer may include any organic/inorganic material having electronic properties.

Hereinafter, the exemplary embodiments are illustrated in further detail with reference to examples. However, embodiments of the present disclosure are not limited to the examples.

EXAMPLES

Analysis Methods

[1] Photoluminescence Analysis

(1) A photoluminescence (PL) spectrum of the nanoparticles produced and a composite including the semiconductor nanoparticles was obtained using a Hitachi F-7000 spectrophotometer at an excitation wavelength of 450 nm.
(2) The absolute quantum yield is measured using QE-2100, Otsuka.

[2] Elemental amount analysis and production yield calculation

(1) Inductively coupled plasma atomic emission spectroscopy (ICP-AES) was performed using a Shimadzu ICPS-8100.
(2) The production yield was calculated by the following method:

$$\text{Production yield} = A/B \times 100$$

A: The total weight of the silver, the Group 13 element, and the sulfur in the semiconductor nanoparticles recovered from the crude solution; and
B: The total weight of the silver, the Group 13 element, and the sulfur added to the reaction medium for the reaction.

The value of B was obtained with ICP analysis of the first semiconductor nanocrystal and the molar ratio of elemental precursors used in the synthesis. The value A was obtained with ICP analysis of the prepared semiconductor nanoparticles.

[3] Optical Density Measurement and UV-Visibility Spectrometry Analysis

(1) A solution for the measurement was prepared by diluting the crude solution n times (e.g., 100 times) and was placed in a cuvette that provides a light path length of 10 mm, i.e., 1 centimeter, and by using a Shimadzu UV-2600, the UV spectroscopic analysis was performed and a UV-visible absorption spectrum was obtained.
(2) A UV-Vis absorbance at a predetermined wavelength (e.g., 500 nm or 350 nm) was read from the UV-visible absorption spectrum, and the obtained absorbance was multiplied again by n times (e.g., 100 times, or the number of dilutions to prepare the sample) to obtain the optical density.

[4] Transmission electron microscopy (TEM) analysis
Transmission electron microscopy analysis of semiconductor nanoparticles was performed using a UTF30 Tecnai electron microscope.

Reference Example 1:

Silver acetate was dissolved in oleylamine to provide a 0.06 molar (M) silver precursor containing solution (hereinafter, "silver precursor"). Sulfur was dissolved in oleylamine to provide a 1 M sulfur precursor containing solution (hereinafter, "sulfur precursor"). Indium chloride was dissolved in ethanol to provide a 1 M indium precursor containing solution (hereinafter, an indium precursor).
Gallium acetylacetonate, octadecene (ODE), and dodecane thiol were placed in a 100 milliliter (mL) reaction flask and heated at 120°C for 10 minutes under vacuum. The flask is cooled to room temperature and nitrogen gas is then added to the flask. The silver precursor, the sulfur precursor, and the indium precursor were added to the flask and the flask was heated to a temperature of 210°C, and a reaction proceeds for 60 minutes. The temperature of the flask was then decreased to 180°C, trioctylphosphine (TOP) was added and the flask was cooled to room temperature. Hexane and ethanol were added to the flask to promote precipitation. The precipitate (i.e., first semiconductor nanocrystal) was separated via centrifugation.
A mole ratio among the indium precursor, the gallium precursor, and the sulfur precursor as used was 1:2.3:4.8.

Example 1

Silver acetate was dissolved in oleylamine to prepare a silver compound solution. Gallium chloride was dissolved in toluene to prepare a 1 M gallium precursor solution (hereinafter, a gallium precursor).
Dimethylthiourea (DMTU) as a sulfur precursor and oleyl amine were placed in a reaction flask, which was then vacuum-treated at 120°C for 10 minutes. Nitrogen gas was added to the reaction flask and the flask heated to 240°C (the first temperature). The first semiconductor nanocrystal obtained in Reference Example1, the gallium precursor, and the silver compound were added to the flask. The reaction flask was heated to 260°C (a second temperature or a reaction temperature) and a reaction proceeded for about 40 minutes. The reaction solution was cooled to 180°C and trioctylphosphine was added to the flask. The reaction mixture was cooled to room temperature to obtain a crude solution including semiconductor nanoparticles.
A mole ratio of the gallium precursor to the sulfur precursor as used was 1:1.3. A mole percent of the silver compound to the gallium precursor (i.e., the used amount of the silver compound based on the gallium precursor) was 3.5 mol%.

A sample was taken from the crude solution, diluted 100 times with toluene (i.e. crude 0.01x), and a UV-Vis absorption spectroscopy analysis and optical density measurement were conducted. The results are summarized in FIG. 8 and Table 1.

Hexane and ethanol were added to the obtained crude solution to promote precipitation to obtain semiconductor nanoparticles, which are separated and recovered by centrifugation. The resulting semiconductor nanoparticles are dispersed in toluene.

An ICP-AES analysis was performed with respect to the obtained semiconductor nanoparticle, and the results are listed in Table 2. A photoluminescence analysis was performed with respect to the obtained semiconductor nanoparticle, and the results are listed in Tables 1 and 2.

Example 2

A crude solution and the semiconductor nanoparticle were obtained in the same manner as in Example 1, except that the amount of the silver compound with respect to the gallium precursor was changed to 2.1 mol% as listed in Table 1.

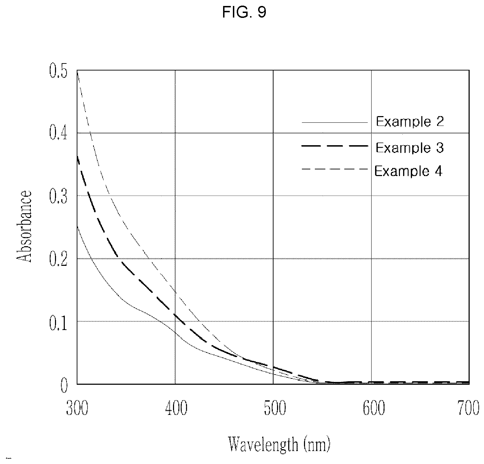

A sample was taken from the crude solution, diluted 100 times with toluene, and a UV-Vis absorption spectroscopy analysis and optical density measurement were conducted. The results are summarized in FIG. 9 and Table 1.

Hexane and ethanol were added to the obtained crude solution to promote precipitation of the semiconductor nanoparticles that are then separated and recovered by centrifugation, and dispersed in toluene.

An ICP-AES analysis was performed with respect to the obtained semiconductor nanoparticle, and the results are listed in Table 2. A photoluminescence analysis was performed with respect to the obtained semiconductor nanoparticle, and the results are listed in Tables 1 and 2.

Example 3

A crude solution and the semiconductor nanoparticle were obtained in the same manner as in Example 1, except that the used amount of the silver compound with respect to the gallium precursor was changed to 4.2 mol% as listed in Table 1.

A sample was taken from the crude solution, diluted 100 times with toluene, and a UV-Vis absorption spectroscopy analysis and optical density measurement were conducted. The results are summarized in FIG. 9 and Table 1.

Hexane and ethanol were added to the obtained crude solution to promote precipitation of the semiconductor nanoparticles that are then separated and recovered by centrifugation, and dispersed in toluene.

An ICP-AES analysis was performed with respect to the obtained semiconductor nanoparticle, and the results are shown in Table 2. A photoluminescence analysis was performed with respect to the obtained semiconductor nanoparticle, and the results are listed in Tables 1 and 2.

Example 4

A crude solution and the semiconductor nanoparticle were obtained in the same manner as in Example 1, except that the used amount of the silver compound with respect to the gallium precursor was changed to 10.4 mol% as listed in Table 1.

A sample was taken from the crude solution, diluted 100 times with toluene, and a UV-Vis absorption spectroscopy analysis and optical density measurement were conducted. The results are summarized in FIG. 9 and Table 1.

Hexane and ethanol were added to the obtained crude solution to promote precipitation of the semiconductor nanoparticles that are then separated and recovered by centrifugation, and dispersed in toluene.

An ICP-AES analysis was performed with respect to the obtained semiconductor nanoparticle, and the results are shown in Table 2. A photoluminescence analysis was performed with respect to the obtained semiconductor nanoparticle, and the results are listed in Tables 1 and 2.

Comparative Example 1

The gallium chloride was dissolved in toluene to prepare a 5.68 M gallium precursor-containing solution (hereinafter, "gallium precursor").

Dimethyl thiourea (DMTU) and oleyl amine were added to a reaction flask and vacuum-treated at 120°C for 10 minutes. Nitrogen gas was added to the reaction flask and the flask heated to 240°C, the first semiconductor nanocrystal and the gallium precursor were added to the flask. The reaction flask was heated to 280°C and a reaction proceeds for about 40 minutes. The reaction solution was cooled to 180°C and trioctylphosphine was added to the flask. The reaction mixture was cooled to room temperature to obtain a crude solution including semiconductor nanoparticles.

A mole ratio of the gallium precursor to the sulfur precursor, which was used in the preparation of the semiconductor nanocrystals of Reference Example 1, was 1:1.3.

A sample was taken from the crude solution, diluted 100 times with toluene, and a UV-Vis absorption spectroscopy analysis and optical density measurement were conducted. The results are summarized in FIG. 8 and Table 1.

Hexane and ethanol were added to the obtained crude solution to promote precipitation of the comparative semiconductor nanoparticles that are then separated and recovered by centrifugation, and dispersed in toluene.

An ICP-AES analysis was performed with respect to the obtained semiconductor nanoparticle, and the results are listed in Table 2. A photoluminescence analysis was performed with respect to the obtained semiconductor nanoparticle, and the results are listed in Tables 1 and 2.

Comparative Example 2

A crude solution and the semiconductor nanoparticle were obtained in the same manner as in Comparative Example 1, except that the used amount of the gallium precursor was reduced by half.

A sample was taken from the crude solution, diluted 100 times with toluene, and a UV-Vis absorption spectroscopy analysis and optical density measurement were conducted. The results are summarized in Table 1.

Hexane and ethanol were added to the obtained crude solution to promote precipitation of the comparative semiconductor nanoparticles that are then separated and recovered by centrifugation, and re-disperse in toluene.

An ICP-AES analysis was performed with respect to the obtained semiconductor nanoparticle, and the results are listed in Table 2. A photoluminescence analysis was performed with respect to the obtained semiconductor nanoparticle, and the results are listed in Tables 1 and 2.

Table 1

| | | crude solution UV absorption | | | photoluminescent properties | | | Production yield (%) |
|---|---|---|---|---|---|---|---|---|
| | Ag injection amount | OD at 350 nm | OD at 500 nm | 500/ 350 ratio | PWL (nm) | FWHM (nm) | QY (%) | |
| Comp. Example 1 | 0 | 7.0 | 0.6 | 0.09 | 529 | 30 | 75 | 4.1 |
| Comp. Example 2 | 0 | 6.3 | 0.4 | 0.06 | 525 | 30 | 69 | 5.4 |
| Example 1 | 3.5 | 14.3 | 1.6 | 0.11 | 524 | 35 | 81 | 18.2 |
| Example 2 | 2.1 | 12.9 | 1.8 | 0.14 | 533 | 37 | 74 | 15.9 |
| Example 3 | 4.2 | 18.4 | 2.6 | 0.14 | 533 | 40 | 70 | 21.5 |
| Example 4 | 10.4 | 25.1 | 2.1 | 0.08 | 521 | 40 | 69 | 24.1 |
| Ag injection amount: mol% of silver compound to gallium<br>PWL: peak emission wavelength<br>FWHM: full width at half maximum<br>QY: Quantum yield | | | | | | | | |

The results of Table 1 confirm that the optical density of the crude solution at both 500 nm and 350 nm of Comparative Examples 1 and 2 was low in comparison to Examples 1 to 4, and the production yield was significantly reduced. In contrast, the semiconductor nanoparticles of Examples 1 to 4 exhibit high levels of optical properties together with a high optical density at 500 nm and 350 nm as well as a high production yield.

Table 2

| | Average particle size (nm) | Particle size distribution (standard deviation with respect to the average) |
|---|---|---|
| Comp. Example 1 | 7.3 | 24% |
| Comp. Example 2 | 6.56 | 26% |
| Example 1 | 5.23 | 12% |
| Example 3 | 5.18 | 14% |

(continued)

|  | Average particle size (nm) | Particle size distribution (standard deviation with respect to the average) |
|---|---|---|
| Example 4 | 5.92 | 15% |

The results of Table 2 confirmed that the semiconductor nanoparticles of Examples 1 to 4 exhibit a remarkably uniform size distribution compared to the semiconductor nanoparticles of Comparative Examples 1 and 2.

Table 3

|  | Ag/In | S/In | Ga/In | Ga/(In+Ga) | Ag/(AIG) | S/(AIG) | Ga/S | CBV |
|---|---|---|---|---|---|---|---|---|
| Comp. Example 1 | 4.06 | 10.31 | 5.46 | 0.85 | 0.39 | 0.98 | 0.53 | 1.14 |
| Comp. Example 2 | 3.05 | 8.87 | 3.73 | 0.79 | 0.39 | 1.14 | 0.42 | 0.97 |
| Example 1 | 2.95 | 8.97 | 4.03 | 0.80 | 0.37 | 1.12 | 0.45 | 1.01 |
| Example 2 | 2.38 | 7.00 | 3.53 | 0.78 | 0.34 | 1.01 | 0.50 | 1.14 |
| Example 3 | 2.66 | 7.83 | 3.89 | 0.80 | 0.35 | 1.04 | 0.50 | 1.11 |
| Example 4 | 4.37 | 10.96 | 5.41 | 0.84 | 0.41 | 1.02 | 0.49 | 1.08 |
| Ag/(AIG) = Ag/(Ag+In+Ga) <br> S/AIG = S/(Ag+In+Ga) <br> CBV: charge balance value = {[Ag]+3([In]+[Ga])}/(2[S]) | | | | | | | | |

Here, [Ag], [In], [Ga], and [S] are the molar contents of silver, indium, gallium, and sulfur in the semiconductor nanoparticles, respectively.

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

**Claims**

1. A method of manufacturing a semiconductor nanoparticle, the method comprising:

   combining a first semiconductor nanocrystal that includes silver, a Group 13 element, and a chalcogen element, with a gallium precursor, a sulfur precursor, and a silver compound in a medium including an organic solvent; and heating the medium to a reaction temperature to obtain a crude solution including the semiconductor nanoparticle,
   wherein the semiconductor nanoparticle comprises silver, indium, gallium, and sulfur, and a size of the semiconductor nanoparticle is greater than or equal to 2 nm and less than or equal to 50 nm.

2. The method of claim 1, wherein

   the crude solution exhibits an optical density defined by Equation 1 at a wavelength of 500 nm that is greater than or equal to 1 and less than or equal to 10:

$$\text{Equation 1}$$

$$\text{Optical density} = \log_{10}(I_O/I_T)$$

   $I_O$ = intensity of incident light supplied to the crude solution, and
   $I_T$ = intensity of transmitted light passing through the crude solution;
   preferably wherein
   the crude solution exhibits an optical density of greater than or equal to 8 and less than or equal to 100 at a wavelength of 350 nm.

3. The method of claims 1 or 2, wherein in the UV-Vis absorption spectrum, a ratio of absorption at 500 nm to absorption at 350 nm ($A_{500}$:$A_{350}$) of the crude solution is greater than or equal to 0.01:1 and less than or equal to 0.8:1; and/or

   wherein the silver compound is added to the medium in an amount of greater than or equal to 0.1 mol% and less than or equal to 50 mol%, with respect to an amount of the gallium precursor added to the medium; and/or
   wherein the silver compound comprises a silver carboxylate, a silver acetylacetonate, a silver halide, or a combination thereof.

4. The method of any of claims 1-3, wherein

   a production yield is greater than or equal to 6%:

$$\text{Production yield} = A/B \times 100$$

   A: a total weight of silver, a Group 13 element, sulfur in the semiconductor nanoparticles recovered from the crude solution
   B: a total weight of silver, Group 13 element, and sulfur added to the medium.

5. The method of any of claims 1-4, wherein the semiconductor nanoparticle exhibits a quantum yield of greater than or equal to 65%; and/or
   wherein the semiconductor nanoparticle has an average size of greater than or equal to 5 nm and less than or equal to 10 nm with a standard deviation of less than or equal to 20% of the average size.

6. The method of any of claims 1-5, wherein

   the semiconductor nanoparticle exhibits a charge balance value that is greater than or equal to 0.8 and less than or equal to 1.3:

$$\text{charge balance value} = \{[Ag] + 3([In]+[Ga])\}/(2[S])$$

   wherein [Ag], [In], [Ga], and [S] are molar amounts of silver, indium, gallium, and sulfur in the semiconductor nanoparticle, respectively.

7. The method of any of claims 1-6, further comprising:

   preparing an additional reaction medium including a zinc precursor in an organic solvent;
   adding the semiconductor nanoparticle and a chalcogen precursor to the additional reaction medium, and heating to a reaction temperature to form a third semiconductor nanocrystal including a zinc chalcogenide on a surface of the semiconductor nanoparticle.

8. Semiconductor nanoparticles comprising silver, indium, gallium, and sulfur,

   wherein an average size of the semiconductor nanoparticles is greater than or equal to 5 nm and less than or equal to 10 nm with a standard deviation of less than or equal to 20% and greater than or equal to 5% of the average size,
   wherein the semiconductor nanoparticle exhibits a charge balance value that is greater than or equal to 0.95 and less than or equal to 1.2:

$$\text{charge balance value} = \{[Ag] + 3([In]+[Ga])\}/(2[S])$$

   wherein [Ag], [In], [Ga], and [S] are molar amounts of silver, indium, gallium, and sulfur in the semiconductor nanoparticle, respectively.

9. The semiconductor nanoparticles of claim 8, wherein

   the semiconductor nanoparticles are configured to emit green light, and

a peak emission wavelength of the green light is greater than or equal to 520 nm and less than or equal to 540 nm; and/or

wherein the charge balance value is greater than or equal to 1 and less than or equal to 1.15.

10. The semiconductor nanoparticles of claims 8 or 9, wherein

a quantum yield of the semiconductor nanoparticles is greater than or equal to 70% and less than or equal to 99%, and

a full width at half maximum of the semiconductor nanoparticles is greater than or equal to 15 nm and less than or equal to 70 nm.

11. The semiconductor nanoparticles of any of claims 8-10, wherein

in the semiconductor nanoparticles,

a mole ratio of gallium to indium (Ga:In) is greater than or equal to 1:1 and less than or equal to 10:1, and

a mole ratio of gallium to silver (Ga:Ag) is greater than or equal to 1.1:1 and less than or equal to 3:1.

12. The semiconductor nanoparticles of any of claims 8-11, wherein

in the semiconductor nanoparticles,

a mole ratio of gallium to a sum of gallium, indium, and silver (Ga:(Ga+In+Ag)) is greater than or equal to 0.45:1 and less than or equal to 0.65:1, and

a mole ratio of a sum of indium and gallium to silver ((In+Ga):Ag) is greater than or equal to 1.2:1 and less than or equal to 3.5:1.

13. The semiconductor nanoparticles of any of claims 8-12, wherein

in the semiconductor nanoparticles,

a mole ratio of silver to a sum of silver, indium, and gallium (Ag:(Ag+In+Ga)) is greater than or equal to 0.2:1 and less than or equal to 0.45:1, and

a mole ratio of sulfur to a sum of silver, indium, and gallium (S:(Ag+In+Ga)) is greater than or equal to 0.8:1 and less than or equal to 1.5:1.

14. The semiconductor nanoparticles of any of claims 8-13, wherein

in the semiconductor nanoparticles,

a mole ratio of gallium to sulfur (Ga:S) is greater than or equal to 0.4:1 and less than or equal to 0.6:1.

15. An electronic device, comprising the semiconductor nanoparticles of any of claims 8-14.

# FIG. 1A

Pattern Preparation by using a photoresist

| coating: spin coating | S1 |

↓

| Pre-bake (PRB) | S2 |

↓

| UV exposure under a Mask (EXP) | S3 |

↓

| Development (DEV) | S4 |

↓

| Post-bake (POB) | S5 |

BM                                    RGB

S6

Repeating three times of patterning process for each pixel

# FIG. 1B

| Production of Ink Composition |

⬇

| Provision of Patterned Substrate |

⬇

| Formation of First Quantum Dot Layer |

⬇

| Formation of Second Quantum Dot Layer |

# FIG.2A

EP 4 506 435 A1

FIG. 2B

# FIG. 3A

<u>1000</u>

# FIG. 3B

FIG. 3C

1000

FIG. 4

FIG. 5A

1000

PX

PX$_1$ PX$_2$ PX$_3$

IV          IV

1000D

1000P

y
z ⊙ → x

FIG. 5B

180

182
185
183
184
181

z
y ⊗ → x

FIG. 5C

180

182
185
183b
186
183a
184
181

z
y → x

183a }183
183b

FIG. 5D

180

182
185
183c
186b
183b
186a
183a
184
181

z
y → x

183a }183          186a }186
183b              186b
183c

FIG. 5E

180

187p 187i 187n

187

# FIG. 6

EP 4 506 435 A1

# FIG. 7A

FIG. 7B

FIG. 8

crude 0.01x

FIG. 9

Europäisches
Patentamt
European
Patent Office
Office européen
des brevets

# EUROPEAN SEARCH REPORT

Application Number

EP 24 19 3592

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 4 245 821 A1 (SAMSUNG ELECTRONICS CO LTD [KR]) 20 September 2023 (2023-09-20) * paragraph [0312]; claims 1-15; examples * | 1-15 | INV. C09K11/02 C09K11/62 |
| X,P | EP 4 372 066 A1 (SAMSUNG ELECTRONICS CO LTD [KR]) 22 May 2024 (2024-05-22) * claims 1-15; examples * | 1-15 | |
| X | EP 4 019 608 A1 (NS MAT INC [JP]) 29 June 2022 (2022-06-29) * claims 1-17; examples 14,15,17-20 * | 1-15 | |
| A | WO 2013/162334 A1 (KOREA RES INST CHEM TECH [KR]) 31 October 2013 (2013-10-31) * claims * | 1-15 | |

**TECHNICAL FIELDS SEARCHED (IPC)**

C09K

The present search report has been drawn up for all claims

| Place of search | Date of completion of the search | Examiner |
|---|---|---|
| The Hague | 30 November 2024 | Lehnert, Andreas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 19 3592

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2024

| Patent document cited in search report | | Publication date | Patent family member(s) | | Publication date |
|---|---|---|---|---|---|
| EP 4245821 | A1 | 20-09-2023 | CN | 116782714 A | 19-09-2023 |
| | | | EP | 4245821 A1 | 20-09-2023 |
| | | | KR | 20230136881 A | 27-09-2023 |
| | | | US | 2023295493 A1 | 21-09-2023 |
| EP 4372066 | A1 | 22-05-2024 | CN | 118048068 A | 17-05-2024 |
| | | | EP | 4372066 A1 | 22-05-2024 |
| | | | JP | 2024073402 A | 29-05-2024 |
| | | | KR | 20240072951 A | 24-05-2024 |
| | | | US | 2024182729 A1 | 06-06-2024 |
| EP 4019608 | A1 | 29-06-2022 | CN | 112752828 A | 04-05-2021 |
| | | | EP | 4019608 A1 | 29-06-2022 |
| | | | JP | 7524766 B2 | 30-07-2024 |
| | | | JP | 2022120222 A | 18-08-2022 |
| | | | JP | WO2021039290 A1 | 04-03-2021 |
| | | | KR | 20210027276 A | 10-03-2021 |
| | | | KR | 20240124431 A | 16-08-2024 |
| | | | TW | 202113038 A | 01-04-2021 |
| | | | US | 2021363422 A1 | 25-11-2021 |
| | | | US | 2024059966 A1 | 22-02-2024 |
| | | | WO | 2021039290 A1 | 04-03-2021 |
| WO 2013162334 | A1 | 31-10-2013 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170052444 A1